# EUROPEAN PATENT APPLICATION

(11) **EP 4 489 335 A1**
(43) Date of publication of application: **08.01.2025**
(21) Application number: 23778123.2
(22) Date of filing: 27.03.2023
(51) Int. Cl.: H04L 1/00, H04L 5/00

(54) **DATA TRANSMISSION METHOD AND COMMUNICATION APPARATUS**

(30) Priority: 31.03.2022 CN 202210335179
(71) Applicant: Huawei Technologies Co., Ltd., Shenzhen, Guangdong 518129 (CN)
(72) Inventor: XIE, Junwen, Shenzhen, Guangdong 518129 (CN); MA, Mengyao, Shenzhen, Guangdong 518129 (CN); LI, Jiahui, Shenzhen, Guangdong 518129 (CN); TANG, Zihan, Shenzhen, Guangdong 518129 (CN); YANG, Xun, Shenzhen, Guangdong 518129 (CN); YAN, Min, Shenzhen, Guangdong 518129 (CN)
(74) Representative: Gill Jennings & Every LLP
(86) International application number: PCT/CN2023/084145
(87) International publication number: WO 2023/185758

(57) **Abstract**

This application provides a data transmission method and a communication apparatus. The method includes: A first apparatus obtains data; determines an index of the data based on a first encoding network and a first data codebook, where the first encoding network is for encoding the data, and the first data codebook includes a correspondence between encoded data and the index; and sends information about the index of the data. Data transmission overheads can be reduced by using the data transmission method and the communication apparatus that are provided in this application.

## Description

This application claims priority to Chinese Patent Application No. 202210335179.0, filed with the China National Intellectual Property Administration on March 31, 2022 and entitled "DATA TRANSMISSION METHOD AND COMMUNICATION APPARATUS", which is incorporated herein by reference in its entirety.

### TECHNICAL FIELD

This application relates to the communication field, and more specifically, to a data transmission method and a communication apparatus.

### BACKGROUND

With increasing maturity of an internet of things, a quantity of terminal devices increases day by day, and data traffic also accordingly increases due to more connections and a lower delay. In addition, rapid development of an artificial intelligence (artificial intelligence, AI) technology plays an important role in promoting evolution of a communication network technology. The AI technology is introduced into a communication system. In an AI model training or model inference process, a parameter, input data, output data, and the like of an AI model usually need to be communicated. Data transmission overheads also accordingly increase. How to reduce the data transmission overheads is a problem that needs to be considered currently.

### SUMMARY

This application provides a data transmission method and a communication apparatus, to reduce data transmission overheads.

According to a first aspect, a data transmission method is provided. The method may be performed by a first apparatus or a component (for example, a chip or a chip system) configured in the first apparatus. This is not limited in this application. The first apparatus may be a terminal device or a network device. The method includes: The first apparatus obtains data; determines an index of the data based on a first encoding network and a first data codebook, where the first encoding network is for encoding the data, and the first data codebook includes a correspondence between encoded data and the index; and sends information about the index of the data.

Based on the foregoing solution, the first apparatus performs encoding processing on the data, and searches the first data codebook for the index corresponding to the encoded data. The encoded data may be understood as data obtained through the encoding. In a transmission process, the first apparatus sends the information about the index. Therefore, this solution can reduce data transmission overheads.

With reference to the first aspect, in some implementations of the first aspect, the information about the index of the data includes a bit sequence, the bit sequence is obtained by processing a floating-point sequence, and the floating-point sequence is obtained by processing the index of the data based on a first information protection network. Specifically, the first apparatus may process the index of the data based on the first information protection network, to obtain the floating-point sequence; further process the floating-point sequence to obtain the bit sequence; and send the bit sequence.

Based on the foregoing solution, the first apparatus processes the index of the data based on the first information protection network. A processing process may be adding redundancy, and may be for error correction. Therefore, this solution can improve accuracy of the index of the communicated data.

With reference to the first aspect, in some implementations of the first aspect, the information about the index of the data includes a bit sequence, the bit sequence is determined based on a first channel codebook and the index of the data, and the first channel codebook includes a correspondence between the index of the data and the bit sequence. Specifically, the first apparatus may determine, based on the first channel codebook, the bit sequence corresponding to the index of the data, and send the bit sequence, where the first channel codebook includes the correspondence between the index of the data and the bit sequence.

Based on the foregoing solution, the first channel codebook includes the correspondence between the index of the data and the bit sequence. Therefore, after determining the index of the data, the first apparatus may directly query the first channel codebook to find the bit sequence corresponding to the index of the data, and send the bit sequence, to reduce processing complexity of the first apparatus and improve processing efficiency. Optionally, the first channel codebook may be obtained through training based on channel noise, so that interference of a channel to transmission can be avoided to some extent.

With reference to the first aspect, in some implementations of the first aspect, the first apparatus obtains the first encoding network and the first data codebook.

It should be understood that the first encoding network and the first data codebook may be obtained by the first apparatus through local training, or may be trained by a second apparatus and sent to the first apparatus.

With reference to the first aspect, in some implementations of the first aspect, the first apparatus obtains the first information protection network or the first channel codebook.

It should be understood that the first information protection network or the first channel codebook may be obtained by the first apparatus through local training, or may be trained by a second apparatus and sent to the first apparatus.

With reference to the first aspect, in some implementations of the first aspect, the first information protection network is obtained through training based on channel state information and an index of training data, where the index of the training data is obtained based on a second encoding network and a second data codebook.

It should be understood that the second encoding network and the second data codebook may be obtained through initial training, or may be the first encoding network and the first data codebook that have not been updated. In a training process, an encoding network and a data codebook are updated each time training is performed. In other words, the first encoding network and the first data codebook may be obtained by training and updating the second encoding network and the second data codebook. After the training data is input into the second encoding network, the encoded data is obtained. The index corresponding to the encoded data may be obtained by querying the second data codebook. The first information protection network is trained based on the index corresponding to the encoded data and the channel state information. The first information protection network obtained through training based on the channel state information can better adapt to a real channel condition.

With reference to the first aspect, in some implementations of the first aspect, the first information protection network is obtained through training based on channel state information, an index of training data, and a loss function, where the loss function is associated with at least one of a codeword distance loss, an information reconstruction loss, and a sequence distance loss. The codeword distance loss is a loss of a distance between a first floating-point sequence and a second floating-point sequence, the first floating-point sequence is obtained by processing a first index based on a second information protection network, and the second floating-point sequence is obtained by processing a second index based on the second information protection network. The information reconstruction loss is a loss of a distance between a third index on which processing has not been performed based on the second information protection network and a third index obtained through processing based on a second information recovery network, and the second information recovery network corresponds to the second information protection network. The sequence distance loss is a loss of a distance between a floating-point sequence and a bit sequence, the floating-point sequence is obtained through processing based on the second information protection network, the bit sequence is a bit sequence included in a second channel codebook, and the second channel codebook is the first channel codebook that has not been updated. The second information protection network is a first information protection network that has not been updated, the first index, the second index, and the third index are obtained based on a second encoding network and a second data codebook, the second encoding network is the first encoding network that has not been updated, and the second data codebook is the first data codebook that has not been updated.

It should be understood that the second information protection network may be the first information protection network that has not been trained and updated. In other words, the first information protection network may be obtained by training and updating the second information protection network. The first index and the second index are obtained by processing different training data samples based on the second encoding network and the second data codebook. The third index may be the first index, may be the second index, or may be an index other than the first index and the second index. This is not limited in this application. An information protection network and an information recovery network are trained together. Considering the loss function in a training process can improve information reconstruction performance, and can enable a network to converge faster and have better anti-noise performance. Specifically, considering the information reconstruction loss can reduce an error (or a distance) between an index and an index obtained through processing based on a channel protection network and the information recovery network; considering the sequence distance loss can reduce an error (or a distance) between a floating-point sequence obtained by processing an index based on the information protection network and a bit sequence closest to the index in a channel codebook; and considering the codeword distance loss can increase a distance between floating-point sequences obtained by processing different indexes based on the channel protection network, to avoid obtaining same or similar floating-point sequences by processing the different indexes based on the channel protection network, which results in selecting a same bit sequence in the channel codebook, so that convergence, anti-noise performance, and performance of the network can be improved.

With reference to the first aspect, in some implementations of the first aspect, the first encoding network and the first data codebook are obtained through training based on training data, a first channel protection network, channel state information, a second encoding network, and a second data codebook, where the first channel protection network includes a first information protection network, a first channel codebook, and a first information recovery network, and the first information recovery network corresponds to the first information protection network.

In this solution, the first channel protection network has been trained. A network parameter of the first channel protection network is nested in a second data task network. The second data task network is trained by using the training data and the channel state information (which may be channel state information that is before the second data task network is trained, or may be channel state information that corresponds when the second data task network is trained, which is not limited in this application), to obtain a first data task network. The second data task network includes the second encoding network, the second data codebook, and a second task execution network. The first data task network includes the first encoding network, the first data codebook, and a first task execution network.

A data task network may be, for example, a data reconstruction network. The data reconstruction network includes an encoding network, a data codebook, and a decoding network. The data reconstruction network may be for processing data into an index based on the encoding network and the data codebook. The decoding network may be understood as a task execution network for data recovery, and may recover encoded data to the data. Certainly, the task execution network may alternatively be another network. For example, the task execution network is for executing tasks such as data identification, classification, segmentation, and detection. That is, after receiving the information about the index of the data, the second apparatus may determine the index of the data based on the information about the index of the data, and determine, based on the data codebook, the encoded data corresponding to the index. The encoded data may be input into the task execution network to execute the tasks such as the identification, the classification, the segmentation, and the detection.

With reference to the first aspect, in some implementations of the first aspect, a length of a codeword in the first data codebook and a quantity of codewords in the first data codebook are associated with a dimension of the encoded data.

With reference to the first aspect, in some implementations of the first aspect, the quantity of codewords is associated with at least one of the following: a compression rate of a data task network, a storage resource of the first apparatus, and performance of the data task network. For example, the data is an intermediate feature. The intermediate feature is for representing an output of a network layer in an end-to-end network (for example, a convolutional neural network). The intermediate feature may be understood as an output of any network layer in the end-to-end network. An intermediate feature output by a lower network layer may be more detailed information, including texture information (the texture information may be description information of a picture, for example, brightness information, color information, and a line structure), and an intermediate feature output by a higher network layer may be more macro information, including structure information (for example, contour information).

With reference to the first aspect, in some implementations of the first aspect, the data task network is a first data reconstruction network, the first data reconstruction network includes at least one of the first encoding network, the first data codebook, and a first decoding network, and the first encoding network corresponds to the first decoding network.

With reference to the first aspect, in some implementations of the first aspect, the first apparatus sends a first decoding network parameter and first data codebook information, where the first decoding network determined based on the first decoding network parameter corresponds to the first encoding network, and the first data codebook information is for determining the first data codebook.

Based on the foregoing solution, the first apparatus locally completes training of the first data reconstruction network, and sends, to the second apparatus, a network parameter used by the second apparatus in a subsequent data transmission process.

With reference to the first aspect, in some implementations of the first aspect, the first apparatus sends a second decoding network parameter and second data codebook information, where a second decoding network determined based on the second decoding network parameter is for training to obtain the first decoding network, the first decoding network corresponds to the first encoding network, and the second data codebook information is for determining the second data codebook.

Based on the foregoing solution, if the second decoding network that may be determined based on the second decoding network parameter and the second data codebook that may be determined based on the second data codebook information are obtained by the first apparatus through initial training, the second decoding network and the second data codebook may be for training to obtain the first decoding network and the first data codebook. If the second decoding network and the second data codebook are an intermediate encoding network and an intermediate data codebook, whether training is continued or is terminated may be determined based on a testing sample in real time. If it is determined, based on the testing sample, that the intermediate encoding network and the intermediate data codebook (that is, the intermediate encoding network and the intermediate data codebook that are circularly trained based on the second decoding network and the second data codebook do not necessarily satisfy a condition) satisfy the condition, the training is terminated; or if it is determined, based on the testing sample, that the intermediate encoding network and the intermediate data codebook (that is, the intermediate encoding network and the intermediate data codebook that are circularly trained based on the second decoding network and the second data codebook do not necessarily satisfy a condition) do not satisfy the condition, the training is continued until a trained encoding network and data codebook satisfy a condition. Satisfying the condition is, for example, that a computing value of a loss function of a trained data task network is less than a first threshold. With reference to the first aspect, in some implementations of the first aspect, the first apparatus sends a first information recovery network parameter, where the first information recovery network determined based on the first information recovery network parameter corresponds to the first information protection network.

Based on the foregoing solution, the first apparatus locally completes training of the first channel protection network, and sends, to the second apparatus, the network parameter used by the second apparatus in the subsequent data transmission process.

With reference to the first aspect, in some implementations of the first aspect, the first apparatus sends a second information recovery network parameter, where the second information recovery network determined based on the second information recovery network parameter is for training to obtain the first information recovery network, and the first information recovery network corresponds to the first information protection network.

Based on the foregoing solution, if the second information recovery network that may be determined based on the second information recovery network parameter is obtained by the first apparatus through initial training, the second information recovery network may be for training to obtain the first information recovery network. If the second information recovery network is an intermediate information recovery network in a training process, whether training is continued or is terminated may be determined based on a testing sample in real time. If it is determined, based on a testing sample, that the intermediate information recovery network (that is, an intermediate result circularly trained based on the second information recovery network does not necessarily satisfy a condition) satisfies the condition, the training is terminated; or if it is determined, based on a testing sample, that the intermediate information recovery network (that is, an intermediate result circularly trained based on the second information recovery network does not necessarily satisfy a condition) does not satisfy the condition, the training is continued until a trained information recovery network satisfies the condition. Satisfying the condition is, for example, that a computing value of a loss function or an information reconstruction loss of a trained channel protection network is less than a second threshold.

According to a second aspect, a data transmission method is provided. The method may be performed by a second apparatus or a component (for example, a chip or a chip system) configured in the second apparatus. This is not limited in this application. The second apparatus may be a terminal device or a network device. The method includes: A second apparatus receives information about an index of data, where the information about the index of the data is for determining the index of the data; and determines, based on a first data codebook, encoded data corresponding to the index of the data, where the first data codebook includes a correspondence between the encoded data and the index.

Based on the foregoing solution, after receiving the information about the index of the data, the second apparatus queries the first data codebook for the encoded data corresponding to the information about the index. In this solution, the data is not directly communicated, but the information about the index is communicated. Therefore, this solution can reduce data transmission overheads.

With reference to the second aspect, in some implementations of the second aspect, the second apparatus receives a bit sequence, and processes the bit sequence based on a first information recovery network, to obtain the index of the data.

Based on the foregoing solution, processing the bit sequence based on the first information recovery network, to obtain the index of the data may be understood as directly processing the received bit sequence based on the first information recovery network, to obtain the index of the data; or may be understood as processing the received bit sequence to obtain a floating-point sequence, and processing the floating-point sequence based on the first information recovery network, to obtain the index of the data. The bit sequence received by the second apparatus may be obtained by a first apparatus through processing based on a first information protection network. A processing process may be adding redundancy, and may be for error correction. Therefore, this solution can improve accuracy of communicated data, and avoid noise interference from a channel as much as possible.

With reference to the second aspect, in some implementations of the second aspect, the second apparatus decodes the encoded data based on a first decoding network, to obtain decoded data.

It should be understood that the first decoding network is an example of a task execution network. After determining the encoded data based on the index of the data, the second apparatus may decode the encoded data based on the first decoding network, to obtain the decoded data. The decoded data is data that is recovered based on a decoding network and on which processing has not been performed based on an encoding network.

With reference to the second aspect, in some implementations of the second aspect, the second apparatus obtains the first decoding network and the first data codebook.

It should be understood that the first decoding network and the first data codebook may be obtained by the second apparatus through local training, or may be trained by the first apparatus and sent to the second apparatus.

With reference to the second aspect, in some implementations of the second aspect, the second apparatus obtains the first information recovery network.

It should be understood that the first information recovery network may be obtained by the second apparatus through local training, or may be trained by the first apparatus and sent to the second apparatus.

With reference to the second aspect, in some implementations of the second aspect, the first information recovery network is obtained through training based on channel state information and an index of training data, where the index of the training data is obtained based on a second encoding network and a second data codebook.

It should be understood that the second encoding network and the second data codebook may be a first encoding network and the first data codebook that have not been updated. In a training process, an encoding network and a data codebook are updated each time training is performed. In other words, the first encoding network and the first data codebook may be obtained by training and updating the second encoding network and the second data codebook. After the training data is input into the second encoding network, the encoded data is obtained. The index corresponding to the encoded data may be obtained by querying the second data codebook. A first channel protection network is trained based on the index corresponding to the encoded data and the channel state information. The first channel protection network obtained through training based on the channel state information can better adapt to a real channel condition. The first channel protection network includes the first information protection network and the first information recovery network.

With reference to the second aspect, in some implementations of the second aspect, the first information recovery network is obtained through training based on uplink channel state information, an index of training data, and a loss function, where the loss function is associated with at least one of a codeword distance loss, an information reconstruction loss, and a sequence distance loss. The codeword distance loss is a loss of a distance between a first floating-point sequence and a second floating-point sequence, the first floating-point sequence is obtained by processing a first index based on a second information protection network, and the second floating-point sequence is obtained by processing a second index based on the second information protection network. The information reconstruction loss is a loss of a distance between a third index on which processing has not been performed based on the second information protection network and a third index obtained through processing based on a second information recovery network, and the second information recovery network corresponds to the second information protection network. The sequence distance loss is a loss of a distance between a floating-point sequence and a bit sequence, the floating-point sequence is obtained through processing based on the second information protection network, the bit sequence is a bit sequence included in a second channel codebook, and the second channel codebook is a first channel codebook that has not been updated. The second information protection network is the first information protection network that has not been updated, the first index, the second index, and the third index are obtained based on a second encoding network and a second data codebook, the second encoding network is a first encoding network that has not been updated, and the second data codebook is the first data codebook that has not been updated.

It should be understood that the second information protection network may be the first information protection network that has not been trained and updated. In other words, the first information protection network may be obtained by training and updating the second information protection network. The first index and the second index are obtained by processing different training data samples based on the second encoding network and the second data codebook. The third index may be the first index, may be the second index, or may be an index other than the first index and the second index. This is not limited in this application. An information protection network and an information recovery network are trained together. Considering the loss function in a training process can improve information reconstruction performance, and can enable a network to converge faster and have better anti-noise performance. Specifically, considering the information reconstruction loss can reduce an error (or a distance) between an index and an index obtained through processing based on a channel protection network and the information recovery network; considering the sequence distance loss can reduce an error (or a distance) between a floating-point sequence obtained by processing an index based on the information protection network and a bit sequence closest to the index in a channel codebook; and considering the codeword distance loss can increase a distance between floating-point sequences obtained by processing different indexes based on the channel protection network, to avoid obtaining same or similar floating-point sequences by processing the different indexes based on the channel protection network, which results in selecting a same bit sequence in the channel codebook, so that convergence, anti-noise performance, and performance of the network can be improved.

With reference to the second aspect, in some implementations of the second aspect, the first decoding network and the first data codebook are obtained through training based on the training data, the channel state information, a first channel protection network, the second encoding network, and the second data codebook, where the first channel protection network includes a first information protection network, the first channel codebook, and the first information recovery network, and the first information recovery network corresponds to the first information protection network.

In this solution, the first channel protection network has been trained. A network parameter of the first channel protection network is nested in a second data task network. The second data task network is trained by using the training data and the channel state information (which may be channel state information that is before the second data task network is trained, or may be channel state information that corresponds when the second data task network is trained, which is not limited in this application) to obtain a first data task network. The second data task network includes the second encoding network, the second data codebook, and a second task execution network. The first data task network includes the first encoding network, the first data codebook, and a first task execution network.

A data task network may be, for example, a data reconstruction network. The data reconstruction network includes an encoding network, a data codebook, and a decoding network. The data reconstruction network may be for processing data into an index based on the encoding network and the data codebook. The decoding network may be understood as a task execution network for data recovery, and may recover encoded data to the data. Certainly, the task execution network may alternatively be another network. For example, the task execution network is for executing tasks such as data identification, classification, segmentation, and detection. That is, after receiving the information about the index of the data, the second apparatus may determine the index of the data based on the information about the index of the data, and determine, based on the data codebook, the encoded data corresponding to the index. The encoded data may be input into the task execution network to execute the tasks such as the identification, the classification, the segmentation, and the detection.

With reference to the second aspect, in some implementations of the second aspect, a length of a codeword in the first data codebook and a quantity of codewords in the first data codebook are associated with a dimension of the encoded data.

With reference to the second aspect, in some implementations of the second aspect, the quantity of codewords is associated with at least one of the following: a compression rate of a data task network, a storage resource of the second apparatus, and performance of the data task network.

For example, the data is an intermediate feature. The intermediate feature is for representing an output of a network layer in an end-to-end network (for example, a convolutional neural network). The intermediate feature may be understood as an output of any network layer in the end-to-end network. An intermediate feature output by a lower network layer may be more detailed information, including texture information (the texture information may be description information of a picture, for example, brightness information, color information, and a line structure), and an intermediate feature output by a higher network layer may be more macro information, including structure information (for example, contour information).

With reference to the second aspect, in some implementations of the second aspect, the data task network is a first data reconstruction network, the first data reconstruction network includes at least one of a first encoding network, the first data codebook, and the first decoding network, and the first encoding network corresponds to the first decoding network.

With reference to the second aspect, in some implementations of the second aspect, the second apparatus receives a first decoding network parameter and first data codebook information, where the first decoding network parameter and the first data codebook information are for determining the first decoding network and the first data codebook.

Based on the foregoing solution, the first apparatus locally completes training of the first data reconstruction network, and sends, to the second apparatus, a network parameter used by the second apparatus in a subsequent data transmission process.

With reference to the second aspect, in some implementations of the second aspect, the second apparatus receives a second decoding network parameter and second data codebook information, where the second decoding network parameter is for determining a second decoding network, the second data codebook information is for determining the second data codebook, and the second decoding network and the second data codebook are for training to obtain the first decoding network and the first data codebook.

Based on the foregoing solution, if the second decoding network that may be determined based on the second decoding network parameter and the second data codebook that may be determined based on the second data codebook information are obtained by the first apparatus through initial training, the second decoding network and the second data codebook may be for training to obtain the first decoding network and the first data codebook. If the second decoding network and the second data codebook are an intermediate encoding network and an intermediate data codebook, whether training is continued or is terminated may be determined based on a testing sample in real time. If it is determined, based on the testing sample, that the intermediate encoding network and the intermediate data codebook (that is, the intermediate encoding network and the intermediate data codebook that are circularly trained based on the second decoding network and the second data codebook do not necessarily satisfy a condition) satisfy the condition, the training is terminated; or if it is determined, based on the testing sample, that the intermediate encoding network and the intermediate data codebook (that is, the intermediate encoding network and the intermediate data codebook that are circularly trained based on the second decoding network and the second data codebook do not necessarily satisfy a condition) do not satisfy the condition, the training is continued until a trained encoding network and data codebook satisfy a condition. Satisfying the condition is, for example, that a computing value of a loss function of a trained data task network is less than a first threshold.

With reference to the second aspect, in some implementations of the second aspect, the second apparatus receives a first information recovery network parameter, where the first information recovery network parameter is for determining the first information recovery network.

Based on the foregoing solution, the first apparatus locally completes training of the first channel protection network, and sends, to the second apparatus, the network parameter used by the second apparatus in the subsequent data transmission process.

With reference to the second aspect, in some implementations of the second aspect, the second apparatus receives a second information recovery network parameter, where the second information recovery network determined based on the second information recovery network parameter is for training to obtain the first information recovery network.

Based on the foregoing solution, if the second information recovery network that may be determined based on the second information recovery network parameter is obtained by the first apparatus through initial training, the second information recovery network may be for training to obtain the first information recovery network. If the second information recovery network is an intermediate information recovery network in a training process, whether training is continued or is terminated may be determined based on a testing sample in real time. If it is determined, based on a testing sample, that the intermediate information recovery network (that is, an intermediate result circularly trained based on the second information recovery network does not necessarily satisfy a condition) satisfies the condition, the training is terminated; or if it is determined, based on a testing sample, that the intermediate information recovery network (that is, an intermediate result circularly trained based on the second information recovery network does not necessarily satisfy a condition) does not satisfy the condition, the training is continued until a trained information recovery network satisfies the condition. Satisfying the condition is, for example, that a computing value of a loss function or an information reconstruction loss of a trained channel protection network is less than a second threshold.

According to a third aspect, a communication apparatus is provided. The apparatus may be a first apparatus or a component (for example, a chip or a chip system) configured in the first apparatus. This is not limited in this application. The first apparatus may be a terminal device or a network device. The apparatus includes a processing unit and a transceiver unit. The processing unit is configured to: obtain data; and determine an index of the data based on a first encoding network and a first data codebook, where the first encoding network is for encoding the data, and the first data codebook includes a correspondence between encoded data and the index. The transceiver unit sends information about the index of the data.

With reference to the third aspect, in some implementations of the third aspect, the processing unit is further configured to: process the index of the data based on a first information protection network, to obtain a floating-point sequence; and further process the floating-point sequence to obtain a bit sequence. The transceiver unit is further configured to send the bit sequence.

With reference to the third aspect, in some implementations of the third aspect, the processing unit is further configured to determine, based on a first channel codebook, a bit sequence corresponding to the index of the data. The transceiver unit is further configured to send the bit sequence, where the first channel codebook includes a correspondence between the index of the data and the bit sequence.

With reference to the third aspect, in some implementations of the third aspect, the processing unit or the transceiver unit is further configured to obtain the first encoding network and the first data codebook.

With reference to the third aspect, in some implementations of the third aspect, the processing unit or the transceiver unit is further configured to obtain the first information protection network or the first channel codebook.

With reference to the third aspect, in some implementations of the third aspect, the first information protection network is obtained through training based on channel state information and an index of training data, where the index of the data is obtained based on a second encoding network and a second data codebook.

With reference to the third aspect, in some implementations of the third aspect, the first information protection network is obtained through training based on channel state information, an index of training data, and a loss function, where the loss function is associated with at least one of a codeword distance loss, an information reconstruction loss, and a sequence distance loss. The codeword distance loss is a loss of a distance between a first floating-point sequence and a second floating-point sequence, the first floating-point sequence is obtained by processing a first index based on a second information protection network, and the second floating-point sequence is obtained by processing a second index based on the second information protection network. The information reconstruction loss is a loss of a distance between a third index on which processing has not been performed based on the second information protection network and a third index obtained through processing based on a second information recovery network, and the second information recovery network corresponds to the second information protection network. The sequence distance loss is a loss of a distance between a floating-point sequence and a bit sequence, the floating-point sequence is obtained through processing based on the second information protection network, the bit sequence is a bit sequence included in a second channel codebook, and the second channel codebook is the first channel codebook that has not been updated. The second information protection network is a first information protection network that has not been updated, the first index, the second index, and the third index are obtained based on a second encoding network and a second data codebook, the second encoding network is the first encoding network that has not been updated, and the second data codebook is the first data codebook that has not been updated.

With reference to the third aspect, in some implementations of the third aspect, the first encoding network and the first data codebook are obtained through training based on training data, a first channel protection network, channel state information, a second encoding network, and a second data codebook, where the first channel protection network includes a first information protection network, a first channel codebook, and a first information recovery network, and the first information recovery network corresponds to the first information protection network.

With reference to the third aspect, in some implementations of the third aspect, a length of a codeword in the first data codebook and a quantity of codewords in the first data codebook are associated with a dimension of the encoded data.

With reference to the third aspect, in some implementations of the third aspect, the quantity of codewords is associated with at least one of the following: a compression rate of a data task network, a storage resource of the first apparatus, and performance of the data task network.

With reference to the third aspect, in some implementations of the third aspect, the data task network is a first data reconstruction network, the first data reconstruction network includes at least one of the first encoding network, the first data codebook, and a first decoding network, and the first encoding network corresponds to the first decoding network.

With reference to the third aspect, in some implementations of the third aspect, the transceiver unit is further configured to send a first decoding network parameter and first data codebook information, where the first decoding network determined based on the first decoding network parameter corresponds to the first encoding network, and the first data codebook information is for determining the first data codebook.

With reference to the third aspect, in some implementations of the third aspect, the transceiver unit is further configured to send a second decoding network parameter and second data codebook information, where a second decoding network determined based on the second decoding network parameter is for training to obtain the first decoding network, the first decoding network corresponds to the first encoding network, and the second data codebook information is for determining the second data codebook.

With reference to the third aspect, in some implementations of the third aspect, the transceiver unit is further configured to send a first information recovery network parameter, where the first information recovery network determined based on the first information recovery network parameter corresponds to the first information protection network.

With reference to the third aspect, in some implementations of the third aspect, the transceiver unit is further configured to send a second information recovery network parameter, where the second information recovery network determined based on the second information recovery network parameter is for training to obtain the first information recovery network, and the first information recovery network corresponds to the first information protection network.

According to a fourth aspect, a communication apparatus is provided. The apparatus may be a second apparatus or a component (for example, a chip or a chip system) configured in the second apparatus. This is not limited in this application. The second apparatus may be a terminal device or a network device. The apparatus includes a processing unit and a transceiver unit. The transceiver unit is configured to receive information about an index of data, where the information about the index of the data is for determining the index of the data. The processing unit is configured to determine, based on a first data codebook, encoded data corresponding to the index of the data, where the first data codebook includes a correspondence between the encoded data and the index.

With reference to the fourth aspect, in some implementations of the fourth aspect, the transceiver unit is further configured to receive a bit sequence. The processing unit is further configured to process the bit sequence based on a first information recovery network, to obtain the index of the data.

With reference to the fourth aspect, in some implementations of the fourth aspect, the processing unit is further configured to decode the encoded data based on a first decoding network, to obtain decoded data.

With reference to the fourth aspect, in some implementations of the fourth aspect, the transceiver unit or the processing unit is further configured to obtain the first decoding network and the first data codebook.

With reference to the fourth aspect, in some implementations of the fourth aspect, the transceiver unit or the processing unit is further configured to obtain the first information recovery network.

With reference to the fourth aspect, in some implementations of the fourth aspect, the first information recovery network is obtained through training based on channel state information and an index of training data, where the index of the data is obtained based on a second encoding network and a second data codebook.

With reference to the fourth aspect, in some implementations of the fourth aspect, the first information recovery network is obtained through training based on uplink channel state information, an index of training data, and a loss function, where the loss function is associated with at least one of a codeword distance loss, an information reconstruction loss, and a sequence distance loss. The codeword distance loss is a loss of a distance between a first floating-point sequence and a second floating-point sequence, the first floating-point sequence is obtained by processing a first index based on a second information protection network, and the second floating-point sequence is obtained by processing a second index based on the second information protection network. The information reconstruction loss is a loss of a distance between a third index on which processing has not been performed based on the second information protection network and a third index obtained through processing based on a second information recovery network, and the second information recovery network corresponds to the second information protection network. The sequence distance loss is a loss of a distance between a floating-point sequence and a bit sequence, the floating-point sequence is obtained through processing based on the second information protection network, the bit sequence is a bit sequence included in a second channel codebook, and the second channel codebook is a first channel codebook that has not been updated. The second information protection network is the first information protection network that has not been updated, the first index, the second index, and the third index are obtained based on a second encoding network and a second data codebook, the second encoding network is a first encoding network that has not been updated, and the second data codebook is the first data codebook that has not been updated.

With reference to the fourth aspect, in some implementations of the fourth aspect, the first decoding network and the first data codebook are obtained through training based on the training data, the channel state information, a first channel protection network, the second encoding network, and the second data codebook, where the first channel protection network includes a first information protection network, the first channel codebook, and the first information recovery network, and the first information recovery network corresponds to the first information protection network.

With reference to the fourth aspect, in some implementations of the fourth aspect, a length of a codeword in the first data codebook and a quantity of codewords in the first data codebook are associated with a dimension of the encoded data.

With reference to the fourth aspect, in some implementations of the fourth aspect, the quantity of codewords is associated with at least one of the following: a compression rate of a data task network, a storage resource of the second apparatus, and performance of the data task network.

With reference to the fourth aspect, in some implementations of the fourth aspect, the data task network is a first data reconstruction network, the first data reconstruction network includes at least one of a first encoding network, the first data codebook, and the first decoding network, and the first encoding network corresponds to the first decoding network.

With reference to the fourth aspect, in some implementations of the fourth aspect, the transceiver unit is further configured to receive a first decoding network parameter and first data codebook information, where the first decoding network parameter and the first data codebook information are for determining the first decoding network and the first data codebook.

With reference to the fourth aspect, in some implementations of the fourth aspect, the transceiver unit is further configured to receive a second decoding network parameter and second data codebook information, where the second decoding network parameter is for determining a second decoding network, the second data codebook information is for determining the second data codebook, and the second decoding network and the second data codebook are for training to obtain the first decoding network and the first data codebook.

With reference to the fourth aspect, in some implementations of the fourth aspect, the transceiver unit is further configured to receive a first information recovery network parameter, where the first information recovery network parameter is for determining the first information recovery network.

With reference to the fourth aspect, in some implementations of the fourth aspect, the transceiver unit is further configured to receive a second information recovery network parameter, where the second information recovery network determined based on the second information recovery network parameter is for training to obtain the first information recovery network.

According to a fifth aspect, a communication apparatus is provided. The apparatus includes a processor. The processor is coupled to a memory, and may be configured to execute instructions in the memory, to implement the method according to any one of the first aspect, the second aspect, or the possible implementations of the first aspect and the second aspect. Optionally, the apparatus further includes the memory. The memory and the processor may be separately deployed, or may be deployed in a centralized manner. Optionally, the apparatus further includes a communication interface. The processor is coupled to the communication interface.

In an implementation, the communication interface may be a transceiver or an input/output interface.

In another implementation, the apparatus is a first apparatus or a second apparatus, or a chip configured in the first apparatus or the second apparatus. When the apparatus is a chip, the communication interface may be an input/output interface, an interface circuit, an output circuit, an input circuit, a pin, a related circuit, or the like on the chip or a chip system. The processor may alternatively be embodied as a processing circuit or a logic circuit.

Optionally, the transceiver may be a transceiver circuit. Optionally, the input/output interface may be an input/output circuit.

In a specific implementation process, the processor may be one or more chips, the input circuit may be an input pin, the output circuit may be an output pin, and the processing circuit may be a transistor, a gate circuit, a trigger, various logic circuits, and the like. An input signal received by the input circuit may be received and input by, but not limited to, a receiver, a signal output by the output circuit may be output to, but not limited to, a transmitter and transmitted by a transmitter. In addition, the input circuit and the output circuit may be a same circuit, and the circuit is used as the input circuit and the output circuit at different moments. Specific implementations of the processor and the various circuits are not limited in this embodiment of this application.

According to a sixth aspect, a communication apparatus is provided. The apparatus includes a logic circuit and an input/output interface. The logic circuit is configured to be coupled to the input/output interface, and communicate data through the input/output interface, to perform the method according to any one of the first aspect, the second aspect, and the possible implementations of the first aspect and the second aspect.

According to a seventh aspect, a computer-readable storage medium is provided. The computer-readable storage medium stores a computer program (which may also be referred to as code or instructions). When the computer program is run on a computer, the computer is enabled to perform the method according to any one of the first aspect, the second aspect, or the possible implementations of the first aspect and the second aspect.

According to an eighth aspect, a computer program product is provided. The computer program product includes a computer program (which may also be referred to as code or instructions). When the computer program is run, a computer is enabled to perform the method according to any one of the first aspect, the second aspect, or the possible implementations of the first aspect and the second aspect.

For specific beneficial effects brought by the third aspect to the eighth aspect, refer to the descriptions of the beneficial effects in the first aspect and the second aspect. Details are not described herein again.

### BRIEF DESCRIPTION OF DRAWINGS

FIG. 1 is a diagram of a network architecture according to an embodiment of this application;
FIG. 2 is a diagram of interaction in a data transmission method according to an embodiment of this application;
FIG. 3 is a diagram of overall network deployment according to an embodiment of this application;
FIG. 4 is a schematic flowchart of training a first data reconstruction network according to an embodiment of this application;
FIG. 5 is a schematic flowchart of training a first channel protection network based on a first data reconstruction network according to an embodiment of this application;
FIG. 6 is a diagram of interaction in unilateral network training according to an embodiment of this application;
FIG. 7 is a diagram of interaction in bilateral interactive network training according to an embodiment of this application;
FIG. 8 is a schematic flowchart of periodically training and updating a network according to an embodiment of this application;
FIG. 9 is a diagram of simulation results of different solutions according to an embodiment of this application;
FIG. 10 is a diagram of a communication apparatus according to an embodiment of this application;
FIG. 11 is a diagram of a structure of a communication apparatus according to an embodiment of this application;
FIG. 12 is a diagram of a structure of another communication apparatus according to an embodiment of this application; and
FIG. 13 is a diagram of a structure of still another communication apparatus according to an embodiment of this application.

### DESCRIPTION OF EMBODIMENTS

The following describes the technical solutions in this application with reference to the accompanying drawings.

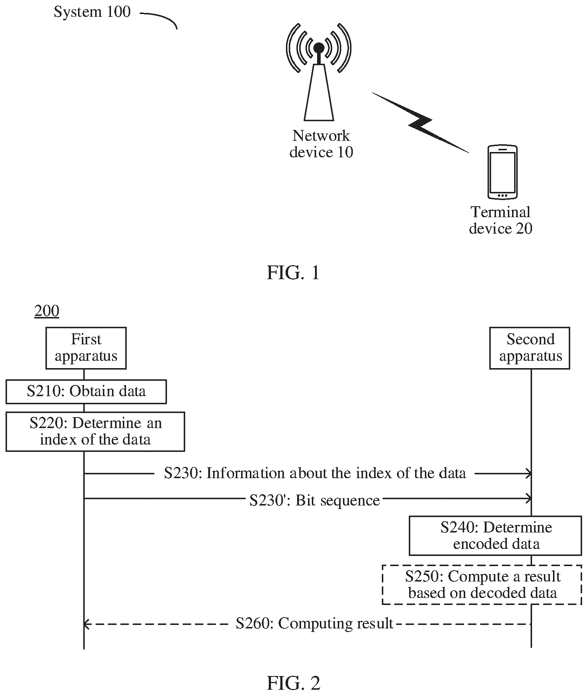

FIG. 1 is a diagram of a network architecture according to an embodiment of this application.

A system 100 shown in FIG. 1 includes a network device 10 and a terminal device 20. The network device 10 and the terminal device 20 may communicate with each other through an uplink and a downlink. Certainly, a system to which embodiments of this application are applicable may further include a plurality of (two or more) network devices and a plurality of terminal devices. Two terminal devices may communicate with each other through a sidelink. FIG. 1 is merely an example. This is not limited in this application.

The terminal device in embodiments of this application may be a wireless terminal device that can receive scheduling and indication information of the network device. The terminal device may be a device that provides voice and/or data connectivity for a user, a handheld device with a wireless connection function, or another processing device connected to a wireless modem.

The terminal device may also be referred to as a terminal, an access terminal, user equipment, a subscriber unit, a subscriber station, a mobile station, a remote station, a remote terminal, a mobile device, a user terminal, a wireless communication device, a user agent, or a user apparatus. The terminal in embodiments of this application may be a mobile phone (mobile phone), a tablet computer (pad), a computer with a wireless transceiver function, a virtual reality (virtual reality, VR) terminal, an augmented reality (augmented reality, AR) terminal, a wireless terminal in industrial control (industrial control), a wireless terminal in self driving (self driving), a wireless terminal in remote medical (remote medical), a wireless terminal in a smart grid (smart grid), a wireless terminal in transportation safety (transportation safety), a wireless terminal in a smart city (smart city), a wireless terminal in a smart home (smart home), a cellular phone, a cordless phone, a session initiation protocol (session initiation protocol, SIP) phone, a wireless local loop (wireless local loop, WLL) station, a personal digital assistant (personal digital assistant, PDA), a handheld device having a wireless communication function, a computing device or another processing device connected to a wireless modem, a vehicle-mounted device, a wearable device, a terminal in a 5G network, a terminal in an evolved network after 5G, or the like.

The wearable device may also be referred to as a wearable intelligent device, and is a general term of wearable devices, for example, glasses, gloves, watches, clothes, and shoes, that are developed by applying wearable technologies to intelligent designs of daily wear. The wearable device is a portable device that is directly worn or integrated into clothes or an accessory of the user. The wearable device is not only a hardware device, but also implements a powerful function through software support, data exchange, and cloud interaction. Generalized wearable intelligent devices include full-featured and large-size devices that can implement complete or partial functions without depending on smartphones, for example, smart watches or smart glasses, and devices that focus only on one type of application function and need to work with other devices such as smartphones, for example, various smart bands or smart jewelry.

The network device in embodiments of this application may be any communication device that is configured to communicate with the user equipment and has a wireless transceiver function, may be a network device deployed on a satellite, or may be a network device deployed on the ground. The network device includes but is not limited to an evolved NodeB (evolved NodeB, eNB), a radio network controller (radio network controller, RNC), a NodeB (NodeB, NB), a base station controller (base station controller, BSC), a base transceiver station (base transceiver station, BTS), a home base station (for example, a home evolved NodeB, HeNB, or a home NodeB, HNB), a base band unit (base band unit, BBU), an access point (access point, AP) in a wireless fidelity (wireless fidelity, Wi-Fi) system, a wireless relay node, a wireless backhaul node, a transmission point (transmission point, TP), a transmission reception point (transmission reception point, TRP), or the like. The network device may alternatively be a gNB in a 5G system such as an NR system, or one antenna panel or a group of antenna panels (including a plurality of antenna panels) of a base station in the 5G system, or may be a network node, for example, a base band unit (BBU) or a distributed unit (distributed unit, DU), that constitutes a gNB or a transmission point.

In some deployment, the gNB may include a central unit (central unit, CU) and the DU. The gNB may further include an active antenna unit (active antenna unit, AAU).

The technical solutions in embodiments of this application may be applied to various communication systems, for example, a satellite communication system, high altitude platform station (high altitude platform station, HAPS) communication, a non-terrestrial network (non-terrestrial network, NTN) system such as an uncrewed aerial vehicle, an integrated communication and navigation (integrated communication and navigation, IcaN) system, a global navigation satellite system (global navigation satellite system, GNSS), an ultra-dense low-orbit satellite communication system, a long term evolution (long term evolution, LTE) system, LTE frequency division duplex (frequency division duplex, FDD), an LTE time division duplex (time division duplex, TDD) system, a universal mobile telecommunications system (universal mobile telecommunications system, UMTS), a 5th generation (5th generation, 5G) system, an evolved communication system after 5G, vehicle-to-everything (vehicle-to-everything, V2X), long term evolution-vehicle (long term evolution-vehicle, LTE-V), an internet of vehicles, machine type communication (machine type communication, MTC), an internet of things (Internet of things, IoT), long term evolution-machine (long term evolution-machine, LTE-M), and machine to machine (machine to machine, M2M), where V2X may include vehicle to network (vehicle to network, V2N), vehicle to vehicle (vehicle to vehicle, V2V), vehicle to infrastructure (vehicle to infrastructure, V2I), vehicle to pedestrian (vehicle to pedestrian, V2P), and the like.

In embodiments of this application, the terminal device may further have an AI processing capability, and the network device may also have the AI processing capability. For example, the terminal device may have a neural-network training capability, a neural-network inference capability, and the like. Optionally, the network device may also have the neural-network training capability, the neural-network inference capability, and the like.

A problem of high data transmission overheads occurs in communication between the terminal devices, communication between the terminal device and the network device, or communication between the network devices in the foregoing communication system. A device-cloud collaboration scenario is used as an example. The terminal device collects data, extracts an intermediate feature based on an AI task network on a terminal device side, and sends the intermediate feature to the network device (the network device may be cloud). The network device may input the intermediate feature into an AI task network on a network device side for computing, to obtain a result; and feed back the result to the terminal device.

The intermediate feature is for representing an output of a network layer in an end-to-end network (for example, a convolutional neural network). The intermediate feature may be understood as an output of any network layer in the end-to-end network. An intermediate feature output by a lower network layer may be more detailed information, including texture information (the texture information may be description information of a picture, for example, brightness information, color information, and a line structure), and an intermediate feature output by a higher network layer may be more macro information, including structure information (for example, contour information). The end-to-end network may be understood as a complete network from an input to an output, and the input and output can be deployed at two ends. For example, the end-to-end network is understood as a process in which an AI task network is deployed at the two ends (including a terminal device end and a network device end, terminal device ends, or network device ends) for training together.

In a process in which the terminal device sends the intermediate feature to the network device, the intermediate feature may be compressed, to avoid high transmission overheads of the intermediate feature.

In a possible implementation, before sending the intermediate feature to the network device, the terminal device encodes and compresses the intermediate feature, for example, by using a joint photographic experts group (joint photographic experts group, JPEG); may further perform, to avoid interference of a channel to a compressed intermediate feature, channel encoding after encoding the intermediate feature, for example, perform low-density parity check (low-density parity check, LDPC)/polar (Polar) encoding on an encoded intermediate feature after encoding the intermediate feature by using the JPEG; and sends an encoded intermediate feature to the network device.

In this implementation, performance of compressing and encoding the intermediate feature depends on a distribution characteristic of the intermediate feature, and there is error transfer in entropy encoding in a compression process. Consequently, after receiving the encoded intermediate feature, the network device obtains an inaccurate result by decoding the encoded intermediate feature and then inputting a decoded intermediate feature into the AI task network on the network device side for computing. In other words, the encoding-and-compression implementation causes a cliff effect on performance of the AI task network. That is, the performance of the AI task network falls off a cliff.

In another possible implementation, a noise layer is added in a process of training the AI task network, to analogize transmission. A trained AI task network is split. A feature encoding module is added to the AI task network on the terminal device side. The terminal device sends an encoded intermediate feature to the network device. Feature decoding is added to the AI task network on the network device side. The intermediate feature sent by the terminal device is decoded, a result is obtained through computing in the AI task network on the network device side, and the computing result is fed back to the terminal device.

In this implementation, adding analog-noise training to the AI task network is mainly focused on. Although this solution can reduce error transfer in a compression process, an analog solution usually has a weaker anti-noise capability than a digital solution, is more likely to be interfered by noise, has a larger performance loss, and is difficult to be combined with an existing digital communication system.

In view of this, this application provides a codebook-based data transmission solution, to implement data compression and reduce data transmission overheads.

FIG. 2 is a diagram of interaction in a data transmission method according to an embodiment of this application. The method is applicable to data transmission between a first apparatus and a second apparatus. The method 200 shown in FIG. 2 includes the following steps.

S210: The first apparatus obtains data.

It should be understood that the data may be data collected by the first apparatus, for example, downlink channel state information (channel state information, CSI) data, or the data may be an intermediate feature extracted from an end-to-end network deployed on a first-apparatus side.

S220: The first apparatus determines an index of the data.

In a possible implementation, the first apparatus determines the index of the data based on a first encoding network and a first data codebook, where the first encoding network is for encoding the data, and the first data codebook includes a correspondence between encoded data and the index.

For example, the first apparatus processes the data based on the first encoding network, to obtain the encoded data; and then queries, based on the encoded data, the first data codebook for an index corresponding to the encoded data.

The index of the data may be understood as the index corresponding to the encoded data, and the encoded data may be understood as data obtained through the encoding.

Optionally, the first apparatus processes the index of the data by using a channel encoding module, for example, adds a parity bit to the index of the data through LDPC or polar, to resist disturbance. The second apparatus may correct an error of the index of the data by using the parity bit.

In a possible implementation, a length of a codeword in the first data codebook and a quantity of codewords in the first data codebook are associated with a dimension of the data.

In a possible implementation, the quantity of codewords is associated with at least one of the following: a compression rate of a data task network, a storage resource of the first apparatus and/or a storage resource of the second apparatus, and performance of the data task network.

For example, the data task network may be a data reconstruction network. The data reconstruction network includes an encoding network, a data codebook, and a decoding network. The data reconstruction network may be for processing data into an index based on the encoding network and the data codebook. The decoding network may be understood as a task execution network for data recovery, and may recover encoded data to the data. The encoding network may be disposed on the first-apparatus side, and the decoding network may be disposed on a second-apparatus side. Optionally, the task execution network may alternatively be another network. For example, the task execution network is for executing tasks such as data identification, classification, segmentation, and detection. That is, after receiving information about the index of the data, the second apparatus may determine the index of the data based on the information about the index of the data, and determine, based on the codebook, the encoded data corresponding to the index. The encoded data may be input into the task execution network to execute the tasks such as identification, classification, segmentation, and detection.

S230: The first apparatus sends the information about the index of the data to the second apparatus. Accordingly, the second apparatus receives the information about the index of the data.

It should be understood that the information about the index of the data may be understood as information that may be for determining the index of the data, and may be the index of the data or information related to the index of the data, where the information related to the index may be for uniquely determining the index of the data. This is not limited in this application.

In a possible implementation, the information about the index of the data may be information about an index that is of the data and that is obtained through processing by using the channel encoding module. The first apparatus may send, to the second apparatus, the information about the index that is of the data and that is obtained through the processing by using the channel encoding module. Accordingly, the second apparatus receives the information about the index that is of the data and that is obtained through the processing.

In a possible implementation, the information about the index of the data includes a bit sequence. In other words, S230 may be replaced with S230'. The first apparatus sends the bit sequence to the second apparatus. Accordingly, the second apparatus receives the bit sequence.

Optionally, the bit sequence may be obtained by processing a floating-point sequence, and the floating-point sequence is obtained by processing the index of the data based on a first information protection network. Specifically, before the first apparatus sends the bit sequence, the first apparatus processes, based on the first information protection network, the index that is of the data and that is determined in S220, to obtain the floating-point sequence; and further processes the floating-point sequence to obtain the bit sequence.

For example, the first apparatus may process the floating-point sequence into the bit sequence in an approximation or codebook-mapping processing manner.

It should be understood that the first information protection network may be for protecting data to be sent by the first apparatus to the second apparatus, to reduce noise interference from a channel. The first information protection network may be a network that is trained by the first apparatus or the second apparatus in advance and deployed on the first-apparatus side.

For example, the first information protection network may be a multi-layer neural network, and may include a convolutional layer, a fully connected layer, and an activation layer. The first information protection network may be for lengthening a dimension of input data (that is, the index), to implement anti-disturbance.

Optionally, the bit sequence is determined based on a first channel codebook and the index of the data. Specifically, before the first apparatus sends the bit sequence, the first apparatus determines, based on the first channel codebook, the bit sequence corresponding to the index of the data. The first channel codebook includes a correspondence between the index of the data and the bit sequence. The first channel codebook is obtained by the first apparatus or the second apparatus through training based on the first information protection network. A floating-point sequence output by processing each index based on the first information protection network is close to or the same as a bit sequence found in the first channel codebook through near neighbor search based on the index.

It should be understood that the first apparatus processes the index into the bit sequence in two manners. In a first manner, the first apparatus processes the index based on the information protection network, to obtain the floating-point sequence; and then processes the floating-point sequence into the bit sequence. In a second manner, the first apparatus obtains, based on the channel codebook, the bit sequence corresponding to the index. When the floating-point sequence output by processing each index based on the first information protection network is close to or the same as the bit sequence found in the first channel codebook through the near neighbor search based on the index, in a subsequent data transmission process, the first apparatus may directly obtain, based on the first channel codebook and without processing performed based on the information protection network, the bit sequence corresponding to the index.

S240: The second apparatus determines the encoded data.

After the second apparatus receives the information about the index of the data in S230, the second apparatus determines, based on the first data codebook, the encoded data corresponding to the index of the data, where the first data codebook includes the correspondence between the encoded data and the index.

The first apparatus encodes the data based on the first encoding network, to obtain the encoded data; and queries the first data codebook for the index corresponding to the encoded data. After receiving the information about the index of the data, the second apparatus queries the first data codebook for the encoded data corresponding to the information about the index.

In a possible implementation, when the received information about the index is the bit sequence, after the second apparatus receives the bit sequence in S230', the second apparatus processes the bit sequence to obtain the floating-point sequence; and processes the floating-point sequence based on a first information recovery network, to obtain the index of the data.

For example, the bit sequence is obtained by the first apparatus by processing the index of the data based on the first information protection network, and the first information recovery network corresponds to the first information protection network. Therefore, the second apparatus may recover the bit sequence to the index of the data based on the first information recovery network.

In a possible implementation, when the received information about the index is the bit sequence, after the second apparatus receives the bit sequence in S230', the second apparatus processes the bit sequence based on the first information recovery network, to obtain the index of the data.

In this solution, the bit sequence does not need to be processed to obtain the floating-point sequence; and the bit sequence may be directly processed based on the first information recovery network, to obtain the index of the data.

For example, after receiving a transmission sequence carried on a carrier, the second apparatus performs hard-decision demodulation on the transmission sequence to obtain the bit sequence. For example, 0.9 may be considered as 1 through hard decision, and 0.1 may be considered as 0 through the hard decision. An input into the first information recovery network may be the floating-point sequence, or may be the bit sequence. Therefore, the bit sequence may be directly processed based on the first information recovery network, to obtain the index of the data.

In a possible implementation, the first information protection network and the first information recovery network are obtained through training based on channel state information, an index of training data, and a loss function. The loss function is associated with at least one of a codeword distance loss, an information reconstruction loss, and a sequence distance loss.

The codeword distance loss is a loss of a distance between a first floating-point sequence and a second floating-point sequence, the first floating-point sequence is obtained by processing a first index based on a second information protection network, and the second floating-point sequence is obtained by processing a second index based on the second information protection network.

The information reconstruction loss is a loss of a distance between a third index on which processing has not been performed based on the second information protection network and a third index obtained through processing based on a second information recovery network, and the second information recovery network corresponds to the second information protection network.

The sequence distance loss is a loss of a distance between a floating-point sequence and a bit sequence, the floating-point sequence is obtained through processing based on the second information protection network, the bit sequence is a bit sequence included in a second channel codebook, the second channel codebook is obtained through training based on the second information protection network, and the first index, the second index, and the third index are obtained based on a second encoding network and a second data codebook.

Considering the loss function in a training process can improve information reconstruction performance, and can enable a network to converge faster and have better anti-noise performance. Specifically, considering the information reconstruction loss can reduce an error (or a distance) between an index and an index obtained through processing based on a channel protection network and an information recovery network; considering the sequence distance loss can reduce an error (or a distance) between a floating-point sequence obtained by processing an index based on an information protection network and a bit sequence closest to the index in a channel codebook; and considering the codeword distance loss can increase a distance between floating-point sequences obtained by processing different indexes based on the channel protection network, to avoid obtaining same or similar floating-point sequences by processing the different indexes based on the channel protection network, which results in selecting a same bit sequence in the channel codebook, so that convergence, anti-noise performance, and performance of the network can be improved.

It should be understood that the first information protection network, the first channel codebook, and the first information recovery network are obtained through a plurality of rounds of training, and the second information protection network, the second channel codebook, and the second information recovery network may be obtained through a previous round of training for the first information protection network, the first channel codebook, and the first information recovery network. Likewise, the first encoding network and the first data codebook are obtained through a plurality of rounds of training, and the second encoding network and the second data codebook may be obtained through a previous round of training for the first encoding network and the first data codebook. The training data in this application is data used in processes of training the foregoing networks, and a type, a dimension, and a purpose of the training data may be the same as those of data communicated after the foregoing networks are trained.

Optionally, the second apparatus inputs the encoded data into a first task execution network for processing. For example, the first task execution network is a first decoding network, and the first decoding network corresponds to the first encoding network.

Optionally, the second apparatus decodes the encoded data based on the first decoding network, to obtain decoded data.

It should be understood that the decoded data is data that is recovered based on a decoding network and on which processing has not been performed based on an encoding network. The decoded data may be the same as data on which processing has not been performed based on the encoding network (for a processing process of same data), or the decoded data may be close to data on which processing has not been performed based on the encoding network.

Optionally, the method 200 further includes the following step.

S250: The second apparatus inputs the decoded data into an end-to-end network on the second-apparatus side, to perform computing to obtain a computing result, where the decoded data is an intermediate feature in the end-to-end network.

It should be understood that the decoded data may be obtained by decoding the encoded data based on the first decoding network.

Optionally, the method 200 further includes the following step.

S260: The second apparatus feeds back the computing result to the first apparatus. Accordingly, the first apparatus receives the computing result.

S250 and S260 may be used in an end-to-end network computing scenario, for example, device-cloud collaboration, model segmentation, and edge computing.

It should be understood that the first apparatus may be a terminal device. In this case, the second apparatus is a network device. Alternatively, the first apparatus is a network device. In this case, the second apparatus is a terminal device. The first apparatus and the second apparatus below are understood likewise.

The first apparatus and the second apparatus may jointly implement a first data task network and an optional first channel protection network. The first data task network may implement, for example, a data reconstruction task. The first channel protection network may reduce channel interference to information communicated between the first apparatus and the second apparatus. Apart of the first data task network may be deployed on the first-apparatus side, and the other part of the first data task network may be deployed on the second-apparatus side.

In a possible implementation, the first data task network includes the first encoding network, the first data codebook, and the first task execution network. Optionally, if the first encoding network and the first data codebook are deployed on the first apparatus, the first task execution network and the first data codebook are deployed on the second apparatus; or if the first task execution network and the first data codebook are deployed on the first apparatus, the first encoding network and the first data codebook are deployed on the second apparatus.

In a possible implementation, the first channel protection network includes the first information protection network, the first channel codebook, and the first information recovery network. Optionally, if the first information protection network and the first channel codebook are deployed on the first apparatus, the first information recovery network is deployed on the second apparatus; or if the first information recovery network is deployed on the first apparatus, the first information protection network and the first channel codebook are deployed on the second apparatus.

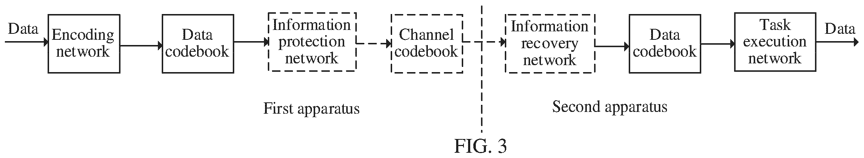

FIG. 3 is a diagram of overall network deployment according to an embodiment of this application. FIG. 3 shows only one of the foregoing listed cases as an example, and other cases may be inferred. Details are not described again.

Dashed-line boxes indicate optional. To be specific, only an encoding network and a data codebook may be deployed on a first-apparatus side, and only the data codebook and a task execution network may be deployed on a second-apparatus side.

Alternatively, an encoding network, a data codebook, and a channel codebook may be deployed on a first-apparatus side, and the data codebook, a task execution network, and an information recovery network may be deployed on a second-apparatus side.

Alternatively, an encoding network, a data codebook, an information protection network, and a channel codebook may be deployed on a first-apparatus side, and an information recovery network, the data codebook, and a task execution network may be deployed on a second-apparatus side.

The following describes a data task network training process by using an example in which a data task network is a data reconstruction network. The training process may be on a first-apparatus side, or may be on a second-apparatus side. This is not limited in this application.

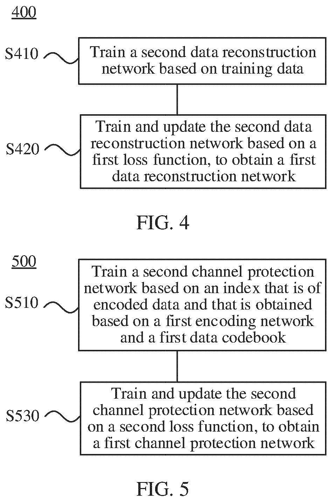

FIG. 4 is a schematic flowchart of training a first data reconstruction network according to an embodiment of this application. A method 400 shown in FIG. 4 as an example includes the following steps.

S410: Train a second data reconstruction network based on training data, where the second data reconstruction network includes a second encoding network, a second data codebook, and a second decoding network.

In a possible implementation, the second encoding network, the second data codebook, and the second decoding network (for example, a network layer, an input or output dimension, and an initialized parameter) are designed based on a compression rate and a storage resource. More network layers indicate more storage resources that are needed and better network performance (for example, a higher compression rate). Therefore, the network layer needs to be designed with a compromise between the storage resource and network performance. Optionally, the initialized parameter may be randomly generated during initial network design.

For example, dimensions of the training data are (c1, a1), and dimensions of encoded data obtained through encoding based on the second encoding network are (c2, a2), where c1 and c2 each may represent a quantity of channels (for example, a quantity of red green blue (red green blue, RGB) channels), and a1 and a2 each may represent a quantity of feature values of a one-dimensional or two-dimensional feature map of each channel. For another example, the training data is an intermediate feature in an end-to-end network, dimensions of the intermediate feature are (c1, a1, b1), and dimensions of an intermediate feature obtained through encoding based on the second encoding network are (c2, a2, b2), where c1 and c2 each may represent a quantity of channels, a1 and a2 each may represent a length of a feature map on a channel, and b1 and b2 may represent a width of the feature map on the channel. For example, the dimensions of the intermediate feature are (2048*4*4), and the dimensions of the intermediate feature obtained through the encoding based on the second encoding network are (512*8*8). * in this application represents an operation symbol "multiplication".

In a possible implementation, a structure of the second data codebook is (d1, k1). d1 is a length of each codeword in the second data codebook, and the length of the codeword in the second data codebook and a quantity of codewords in the second data codebook are associated with a dimension of encoded data. If the training data is an intermediate feature, d1 may represent a quantity of channels of the encoded data, and each codeword in the second data codebook can be approximately a data sequence whose length is the same as a first dimension value (for example, the quantity of channels) of the encoded data. k1 is the quantity of codewords in the second data codebook, and k1 may be set based on one or more of a storage resource, a compression rate, and performance. The storage resource may be a local storage resource of a first apparatus and/or a local storage resource of a second apparatus. The compression rate may be a ratio of a quantity of integers or floating-point numbers of the training data to a quantity of modulation symbols. Assuming that the training data is the intermediate feature, and dimensions of the intermediate feature are (c1, a1, b1), the compression rate is a ratio of a quantity of integer values of a feature map (for example, a quantity of pixel values of the feature map, that is, c1*a1*b1) to the quantity of modulation symbols (for example, a quantity of modulation symbols to which information about an index corresponding to an encoded intermediate feature is mapped in a transmission process), and the performance may be performance of an end-to-end network. For example, if the encoded data is two-dimensional, and dimensions of the encoded data are (c2, a2), a2 data sequences need to be mapped to codewords neighboring to the a2 data sequences in the second data codebook. If the encoded data is three-dimensional, and dimensions of the encoded data are (c2, a2, b2), a2*b2 data sequences need to be mapped to codewords neighboring to the a2*b2 data sequences in the second data codebook. k1 is usually set to 2^{m}, m is a bit stream length of an index corresponding to the encoded data in the second data codebook, and a larger value of m indicates a lower compression rate and a smaller performance loss. Therefore, the second data reconstruction network needs to be designed with a compromise between the compression rate and performance.

It should be understood that a smaller value of k1 indicates a higher compression rate and poorer performance of the data reconstruction network, and more storage resources indicate better performance of the data reconstruction network. Therefore, when the second encoding network and the second data codebook are designed, consideration is needed with a compromise between the compression rate, the storage resource (the storage resource at a first-apparatus end and/or the storage resource at a second-apparatus end), and performance of the data reconstruction network or the end-to-end network (consideration is needed if the training data is the intermediate feature).

For example, a structure of the second data codebook is (512*256). That is, the second data codebook includes 256 codewords, and a length of each codeword is 512. Dimensions of the encoded intermediate feature are (512*8*8), where 512 (512 may be a quantity of channels) in the dimensions of the encoded intermediate feature corresponds to the length, namely, 512, of the codeword in the second data codebook, and 8*8 values in the dimensions of the encoded intermediate feature correspond to 64 codewords in the second data codebook. An index of the codeword in the second data codebook may be represented by using eight bits.

S420: Train and update the second data reconstruction network based on a first loss (loss) function, to obtain the first data reconstruction network, where the first data reconstruction network includes a first encoding network, a first data codebook, and a first decoding network.

In a possible implementation, First loss function=α1*Data reconstruction loss+β1*Codeword distance loss+γ1*Data distance loss. Assuming that training data X is encoded based on the second encoding network, an index corresponding to encoded training data X is obtained, encoded data corresponding to the index in the second data codebook is queried for, and X̂ is obtained by decoding the encoded data based on the second decoding network, the data reconstruction loss is a loss of a difference between X and X̂, for example, a mean squared error (mean squared error, MSE) between X and X̂. The codeword distance loss is a loss caused by updating the codeword in the second data codebook so that an updated codeword is close to the encoded data encoded based on the second encoding network. For example, the codeword distance loss is an MSE between the updated codeword and the encoded data. The data distance loss is a loss caused by fixing the second data codebook and training and updating the second encoding network so that encoded data encoded based on a trained and updated second encoding network approaches the codeword in the second data codebook. For example, the data distance loss is an MSE between the encoded data obtained through encoding after the second encoding network is updated and the codeword in the second data codebook.

The data reconstruction loss may be understood as an example of a data task loss. The data task loss is based on a corresponding task. For example, when the task is data reconstruction, the data task loss is the data reconstruction loss. When the task is classification, the data task loss is a classification loss, that is, a loss between a result obtained by inputting the encoded data into a classification network and a classification label. α1, β1, and γ1 may be set based on actual application. During the setting, a weight occupied by a corresponding part may be considered. It is assumed that α1+β1+γ1=1. When it is considered that the data reconstruction loss is more important than a codeword near-neighbor loss and a data near-neighbor loss, α1 may be set to 0.4, and β1 and γ1 may be set to 0.3. The foregoing is merely an example. This is not limited in this application.

It should be understood that a process of training and updating the data reconstruction network may be repeated until a computing value of the first loss function satisfies a condition. For example, the computing value of the first loss function is less than a first threshold. The first threshold may be predefined or preconfigured, or may be indicated by using signaling. This is not limited in this application. In other words, at least one training and updating process is needed in a process of training and updating the second data reconstruction network to obtain the first data reconstruction network.

For a data task network obtained through training by using the method 400, only information about an index corresponding to data may be communicated in an actual transmission process, so that transmission bit overheads for the data are greatly reduced, compression is high, and combination with an existing digital communication system is easy. In addition, for task-oriented neural networks, probabilities of index occurrence are unequal, which provides a basis for implementing unequal information protection (unequal message protection, UMP).

The following describes a process of training a first channel protection network. The training process may be on a first-apparatus side, or may be on a second-apparatus side. This is not limited in this application. Specifically, a channel protection network may be trained based on a trained first data reconstruction network.

FIG. 5 is a schematic flowchart of training a first channel protection network based on a first data reconstruction network according to an embodiment of this application. A method 500 shown in FIG. 5 as an example includes the following steps.

S510: Train a second channel protection network based on an index that is of encoded data and that is obtained based on a first encoding network and a first data codebook, where the second channel protection network includes a second information protection network, a second channel codebook, and a second information recovery network.

For example, a bit length of the index that is of the encoded data and that is obtained based on the first encoding network and the first data codebook is m. The second information protection network may be designed based on a code rate (m, n). The second information protection network is a process of adding redundancy, and may be for error correction. A length of a floating-point sequence obtained by processing, based on the second information protection network, an index bit sequence whose length is m is n, where m is greater than or equal to n.

For example, the length of the floating-point sequence output by the second information protection network is n, and the floating-point sequence is mapped to a closest bit sequence in the second channel codebook (for example, a length of a codeword in the second channel codebook is n, and a quantity of codewords in the second channel codebook is 2ⁿ).

It should be understood that the second information recovery network may recover the index of the data based on the bit sequence. Through a plurality of times of training, the second information protection network and the second channel codebook may be updated. For example, the second channel codebook is trained and updated until the quantity of codewords changes to 2^{m}. That is, the second channel codebook stores only codewords that one-to-one correspond to index bit sequences output based on the first encoding network and the first data codebook.

S520: Train and update the second channel protection network based on a second loss function, to obtain the first channel protection network, where the first channel protection network includes a first information protection network, a first channel codebook, and a first information recovery network.

Optionally, the second loss function is associated with at least one of a codeword distance loss, an information reconstruction loss, and a sequence distance loss.

For example, Second loss function==α2*Information reconstruction loss.

Alternatively, Second loss function==α2*Information reconstruction loss-y2*Codeword distance loss.

Alternatively, Second loss function=α2*Information reconstruction loss+(32*Sequence distance loss-y2*Codeword distance loss.

It should be understood that the second loss function is not limited to the foregoing examples. Other cases of the second loss function are not listed one by one herein. α2, β2, and γ2 may be set based on actual application. During the setting, a weight occupied by a corresponding part may be considered.

For example, α2+β2+γ2=1. When it is considered that the information reconstruction loss is more important than the codeword distance loss and the sequence example loss, α2 may be set to 0.6, and β2 and γ2 may be set to 0.2. The foregoing is merely an example. This is not limited in this application.

The information reconstruction loss is a loss of a distance between a third index on which processing has not been performed based on the second information protection network and a third index obtained through processing based on the second information recovery network, and the second information recovery network corresponds to the second information protection network.

The codeword distance loss is a loss of a distance between a first floating-point sequence and a second floating-point sequence, the first floating-point sequence is obtained by processing a first index based on the second information protection network, and the second floating-point sequence is obtained by processing a second index based on the second information protection network.

The sequence distance loss is a loss of a distance between a floating-point sequence and a bit sequence, the floating-point sequence is obtained through processing based on the second information protection network, the bit sequence is a bit sequence included in the second channel codebook, the second channel codebook is obtained through training based on the second information protection network, and the first index, the second index, and the third index are obtained based on the first encoding network and the first data codebook.

It should be understood that the first index and the second index are obtained by processing different training data samples based on the first encoding network and the first data codebook. The third index may be the first index, may be the second index, or may be an index other than the first index and the second index. This is not limited in this application.

For example, two different samples in one batch (batch) are input into the second information protection network to output *xᵢ* and *xⱼ* (i and j E 0 to 8, and 8 is a quantity of samples in the batch, and is merely an example), a distance d between bit sequences to which *xᵢ* and *xⱼ* are mapped in the second channel codebook is computed, a loss of a distance between *xᵢ* and *xⱼ* are weighted based on a reciprocal of d (when d=0, γ2=1), to avoid that indexes of the different training data samples input into the second information protection network correspond to a same bit sequence in the second channel codebook, and enable a distance between two bit sequences to which the indexes of the different training data samples input into the second information protection network correspond in the second channel codebook to be longer and enable an anti-interference capability to be stronger.

It should be understood that a process of training the channel protection network may be repeated until a computing value of the information reconstruction loss or the second loss function satisfies a condition. For example, the computing value of the information reconstruction loss or the second loss function is less than a second threshold. The second threshold may be predefined or preconfigured, or may be indicated by using signaling. This is not limited in this application. In other words, at least one training process is needed in a process of training the second channel protection network to obtain the first channel protection network.

In an actual transmission process of the index of the data, a value of each m-length index bit sequence may be for obtaining or used as an index of a bit sequence corresponding to the index bit sequence in the first channel codebook. That is, in the actual transmission process of the data, processing based on an information protection network does not need to be performed, and a bit sequence that corresponds to the index of the data and that needs to be communicated may be directly obtained based on the first channel codebook. For example, if the index corresponding to the data is 00000000, and a value of the index is 0, a bit sequence corresponding to 0 may be selected for transmission based on a correspondence in the first channel codebook.

It should be further understood that, after the first channel protection network is trained, a first channel protection network parameter may be nested in the first data reconstruction network trained according to the method 400, to obtain, through training or updating, a data reconstruction network that is based on channel noise. That is, the first data reconstruction network is trained and updated based on the channel protection network, and an index of noisy data may be obtained based on an updated first data reconstruction network.

According to the method 500, because probabilities of index bit sequence occurrence are unequal, the channel protection network provides unequal protection for the index bit sequence, and a codebook distance loss can well improve reconstruction performance of index bit sequence recovery.

The following describes a manner of training a data task network (a data reconstruction network is used as an example) and/or a channel protection network, for example, unilateral training and bilateral interactive training.

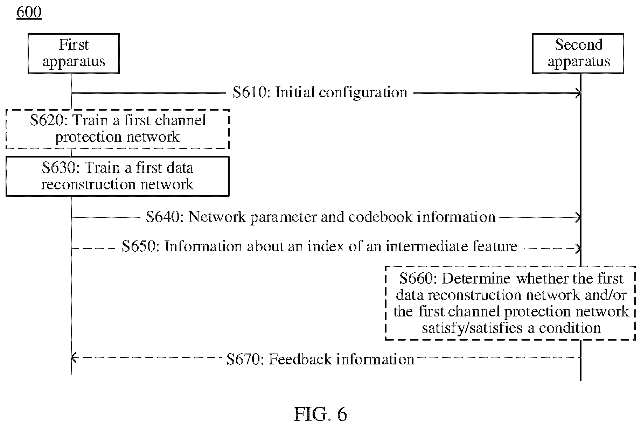

FIG. 6 is a diagram of interaction in unilateral training of a data reconstruction network and/or a channel protection network according to an embodiment of this application. A method 600 shown in FIG. 6 includes the following steps.

S610: A first apparatus sends an initial configuration to a second apparatus. Accordingly, the second apparatus receives the initial configuration.

For example, the initial configuration includes related information of a second data reconstruction network. Assuming that the first apparatus is a terminal device, the initial configuration includes a second decoding network parameter and second data codebook information, the second decoding network parameter may be for determining a second decoding network, and the second data codebook information may be for determining a second data codebook. Alternatively, assuming that the first apparatus is a network device, the initial configuration includes a second encoding network parameter and second data codebook information, and the second encoding network parameter may be for determining a second encoding network.

It should be understood that the second encoding network, the second decoding network, and the second data codebook may be obtained by the first apparatus through initial training.

Alternatively, for example, the initial configuration includes network parameter information that is of an end-to-end network and that is on a second-apparatus side, for example, information such as a weight and a bias in the network.

Alternatively, for example, the initial configuration includes network parameter information that is of an end-to-end network and that is on a second-apparatus side, and related information of a second data reconstruction network.

Alternatively, for example, the initial configuration includes network parameter information that is of an end-to-end network and that is on a second-apparatus side, related information of a second data reconstruction network, and a sample label of the end-to-end network.

Optionally, S620: The first apparatus trains a first channel protection network.

In a possible implementation, the first apparatus obtains a first information protection network through training based on channel state information and an index of training data, where the index of the training data is obtained based on the second encoding network and the second data codebook.

For example, the first apparatus obtains the index of the training data based on the second encoding network and the second data codebook, and trains, based on the obtained channel state information, the first information protection network that is based on channel noise. For a specific training process, refer to the method 500. Details are not described herein again.

Optionally, before S620, the first apparatus obtains the channel state information.

For example, if the first apparatus is a terminal device, and the second apparatus is a network device, the first apparatus sends a channel measurement sequence to the second apparatus (the channel measurement sequence may be sent via a signal such as a channel sounding signal (sounding reference signal, SRS), and the first apparatus may send the channel measurement sequence via the CSI in a case of an uplink-downlink symmetric channel), and the second apparatus feeds back uplink channel state information to the first apparatus. If the first apparatus is a network device, and the second apparatus is a terminal device, the first apparatus receives a channel measurement sequence from the second apparatus, and obtains downlink channel state information.

S630: The first apparatus trains a first data reconstruction network.

In a possible implementation, the first apparatus trains the first data reconstruction network based on the training data, the second encoding network, the second decoding network, the second data codebook, and the channel state information. The second encoding network, the second decoding network, and the second data codebook may be obtained by the first apparatus through the initial training. For a specific training process, refer to the descriptions of the method 400. Details are not described herein again.

In a possible implementation, the first apparatus obtains the first channel protection network through training, nests a network parameter of the first channel protection network in the second data reconstruction network, and obtains the first data reconstruction network through training based on the training data and the channel state information, where the second data reconstruction network includes the second encoding network, the second decoding network, and the second data codebook, and may be obtained by the first apparatus through the initial training. For a specific training process, refer to the descriptions of the method 500. Details are not described herein again.

The foregoing channel state information may be channel state information that corresponds when the second data reconstruction network is trained, or may be channel state information that corresponds when the first data reconstruction network is trained. This is not limited in this application.

S640: The first apparatus sends a network parameter and codebook information to the second apparatus. Accordingly, the second apparatus receives the network parameter and the codebook information.

For example, assuming that the first apparatus completes training of the first data reconstruction network, and the first apparatus is a terminal device, the first data reconstruction network is split into a first encoding network and a first decoding network, the network parameter is a first decoding network parameter and may be for determining the first decoding network, and the codebook information is first data codebook information and may be for determining a first data codebook. Alternatively, if the initial configuration sent in 610 includes the second decoding network parameter and the second data codebook information, the network parameter may be a delta between the second decoding network parameter and a first decoding network parameter, and the codebook information may be a delta between first data codebook information and the second data codebook information.

Alternatively, assuming that the first apparatus is a network device, the first data reconstruction network is split into a first encoding network and a first decoding network, the network parameter is a first encoding network parameter and may be for determining the first encoding network, and the codebook information is first data codebook information and may be for determining a first data codebook. Alternatively, if the initial configuration sent in 610 includes the second encoding network parameter and the second data codebook information, the network parameter may be a delta between the second encoding network parameter and a first encoding network parameter, and the codebook information may be a delta between first data codebook information and the second data codebook information.

Optionally, the network parameter includes the first channel protection network parameter in addition to a first data reconstruction network parameter.

For example, assuming that the first apparatus is a terminal device, the network parameter includes a first information recovery network parameter in addition to the first data reconstruction network parameter, where the first information recovery network parameter is for determining a first information recovery network. Alternatively, assuming that the first apparatus is a network device, the network parameter includes a first information protection network parameter in addition to the first data reconstruction network parameter, where the first information protection network parameter is for determining the first information protection network; and the codebook information further includes first channel codebook information for determining a first channel codebook.

Optionally, if the first data reconstruction network and the first channel protection network are for communicating and recovering an intermediate feature extracted from the end-to-end network, the method 600 further includes the following steps.

S650: The first apparatus sends information about an index of the intermediate feature to the second apparatus, where the index that is of the intermediate feature and that can be determined based on the information about the index of the intermediate feature is obtained through processing based on the first encoding network and the first data codebook. Accordingly, the second apparatus receives the information about the index of the intermediate feature.

S660: The second apparatus determines whether the first data reconstruction network and/or the first channel protection network satisfy/satisfies a condition.

In a possible implementation, the second apparatus recovers, based on the first decoding network, the intermediate feature corresponding to the information about the index of the intermediate feature, inputs the intermediate feature into the end-to-end network to compute a result, and compares a distance (that is, a loss or performance of the end-to-end network) between the result and the sample label included in the initial configuration, to determine whether the distance satisfies the condition.

S670: The second apparatus sends feedback information to the first apparatus. Accordingly, the first apparatus receives the feedback information.

For example, if the loss of the end-to-end network satisfies the condition, that is, the loss of the end-to-end network is less than or equal to a third threshold (which may be predefined or preconfigured, or indicated by using signaling; and this is not limited in this application), the second apparatus sends the feedback information to the first apparatus, where the feedback information indicates that the first data reconstruction network and/or the first channel protection network satisfy/satisfies the condition; and the first apparatus no longer continues training. Subsequent data transmission may be processed based on the first data reconstruction network and/or the first channel protection network.

If the loss of the end-to-end network does not satisfy the condition, that is, the loss of the end-to-end network is greater than a specified third threshold, the second apparatus sends the feedback information to the first apparatus, where the feedback information indicates that the first data reconstruction network and/or the first channel protection network do/does not satisfy the condition. The second apparatus receives the feedback information, and continues to train the first data reconstruction network and/or the first channel protection network (S620 and S630 are repeated) until the condition is satisfied. The feedback information may further indicate the first apparatus to continue to train the first data reconstruction network, indicate the first apparatus to continue to train the first channel protection network, or indicate the first apparatus to continue to train the first data reconstruction network and the first channel protection network.

Alternatively, there is another solution parallel to S650+S660+S670. To be specific, the first apparatus may determine whether the trained first data reconstruction network and/or first channel protection network satisfy/satisfies the condition. A determining method is similar to the foregoing determining method of the second apparatus. Details are not described again.

In the method 600, a process of training the first data reconstruction network and/or the first channel protection network is decoupled from the end-to-end network, so that a data reconstruction network and/or a channel protection network can be fine-tuned without tuning the end-to-end network. Therefore, training is fast, and network parameter transmission overheads can be reduced.

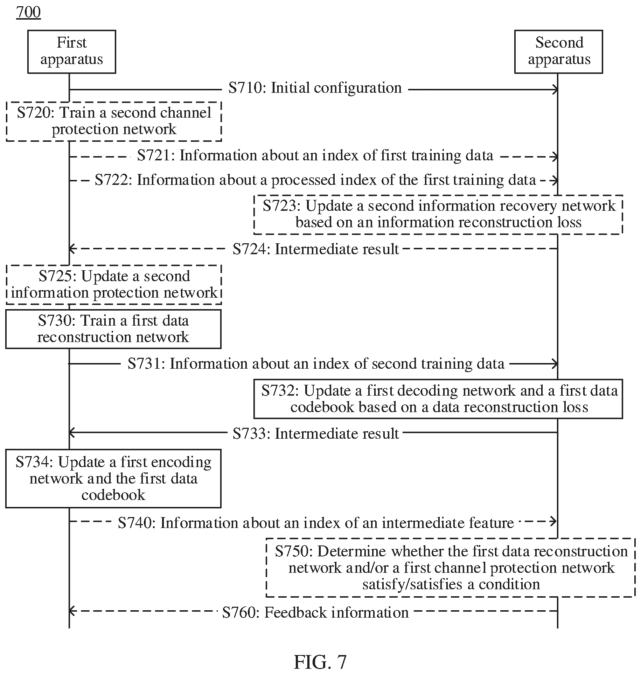

FIG. 7 is a diagram of interaction in bilateral interactive training of a data reconstruction network and/or a channel protection network according to an embodiment of this application. A method 700 shown in FIG. 7 includes the following steps.

S710: A first apparatus sends an initial configuration to a second apparatus. Accordingly, the second apparatus receives the initial configuration.

For example, the initial configuration includes related information of a second data reconstruction network. Assuming that the first apparatus is a terminal device, the initial configuration includes a second decoding network parameter and second data codebook information, the second decoding network parameter may be for determining a second decoding network, and the second data codebook information may be for determining a second data codebook. Alternatively, assuming that the first apparatus is a network device, the initial configuration includes a second encoding network parameter and second data codebook information, and the second encoding network parameter may be for determining a second encoding network.

It should be understood that the second encoding network, the second decoding network, and the second data codebook may be obtained by the first apparatus through initial training.

Alternatively, for example, the initial configuration includes network parameter information that is of an end-to-end network and that is on a second-apparatus side, related information of a second data reconstruction network, and a training data sample, and the network parameter information that is of the end-to-end network and that is on the second-apparatus side is, for example, a weight and a bias in the network.

Alternatively, for example, the initial configuration includes network parameter information that is of an end-to-end network and that is on a second-apparatus side, related information of a second data reconstruction network, a testing sample label (for testing performance of the end-to-end network) of the end-to-end network, a training data sample label (for computing a data reconstruction loss of the data reconstruction network), and a training sample label (for ensuring that samples for network training on a first-apparatus side and the second-apparatus side are the same).

Optionally, S720: The first apparatus trains a second channel protection network.

In a possible implementation, the first apparatus obtains a second information protection network through training based on channel state information and an index of training data, where the index of the training data is obtained based on the second encoding network and the second data codebook.

For example, the first apparatus obtains the index of the training data based on the second encoding network and the second data codebook, and trains, based on the obtained channel state information, the second information protection network that is based on channel noise. For a specific training process, refer to the method 500. Details are not described herein again.

Optionally, S721: The first apparatus sends information about an index of first training data to the second apparatus. Accordingly, the second apparatus receives the information about the index of the first training data.

It should be understood that the information about the index of the first data is obtained through processing based on the second encoding network, the second data codebook, and the second information protection network.

Optionally, S722: The first apparatus sends information about a processed index of the first training data to the second apparatus. Accordingly, the second apparatus receives the information about the processed index of the first training data.

It should be understood that the information about the processed index of the first training data is obtained based on the second encoding network, the second data codebook, and channel anti-interference processing, and the information about the processed index of the first training data can avoid channel interference.

Optionally, S723: The second apparatus updates a second channel protection network (for example, a second information recovery network) on the second-apparatus side based on an information reconstruction loss.

For example, the second apparatus computes the information reconstruction loss based on the information about the index of the first training data and the information about the processed index of the first training data, and updates the second channel protection network (for example, the second information recovery network) on the second-apparatus side based on the information reconstruction loss.

It should be understood that, before S723, the second apparatus obtains the second channel protection network from the first apparatus.

Optionally, in S724, the second apparatus sends, to the first apparatus, an intermediate result (for example, a gradient) needed by the second channel protection network (for example, the second information protection network) on the first-apparatus side to update a network parameter. Accordingly, the first apparatus receives the intermediate result.

For example, the intermediate result is obtained by the second apparatus through computing based on the information reconstruction loss and the information recovery network. The intermediate result may be gradient information, or may be intermediate information for determining the gradient information. This is not limited in this application.

Optionally, S725: The first apparatus determines the gradient information based on the intermediate result, and updates the second channel protection network (for example, the second information protection network) on the first-apparatus side, to obtain a first channel protection network (for example, a first information protection network).

It should be understood that gradient information of a non-data-reconstruction loss may be locally updated by the first apparatus, and does not need to be fed back by the second apparatus. That is, steps between S721 and S724 may not be needed.

S730: The first apparatus trains a first data reconstruction network

In a possible implementation, the first apparatus trains the first data reconstruction network based on the second encoding network, the second decoding network, and the second data codebook. The second encoding network, the second decoding network, and the second data codebook may be obtained by the first apparatus through the initial training. For a specific training process, refer to the descriptions of the method 400. Details are not described herein again.

In a possible implementation, the first apparatus obtains the first channel protection network through training, and nests a network parameter of the first channel protection network in the second data reconstruction network, to obtain the first data reconstruction network through training, where the second data reconstruction network includes the second encoding network, the second decoding network, and the second data codebook, may be obtained by the first apparatus through the initial training, or may be a data reconstruction network that is obtained by the first apparatus through training performed at least once and that satisfies a condition. For a specific training process, refer to the descriptions of the method 500. Details are not described herein again.

S731: The first apparatus sends information about an index of second training data to the second apparatus. Accordingly, the second apparatus receives the information about the index of the second training data.

It should be understood that the information about the index of the second training data is obtained through processing based on a first encoding network and a first data codebook that are obtained through training and updating in S730 and an updated second information protection network (namely, the first information protection network) in S725.

S732: The second apparatus updates a first data reconstruction network (for example, a first decoding network and the first data codebook) on the second-apparatus side based on the data reconstruction loss.

For example, the second apparatus computes the data reconstruction loss based on the training data sample label included in the initial configuration and second data recovered based on the information about the index of the second training data, the first decoding network, and the first data codebook, and updates the first data reconstruction network on the second-apparatus side based on the data reconstruction loss.

S733: The second apparatus sends, to the first apparatus, an intermediate result (for example, a gradient) needed by the first data reconstruction network (for example, the first encoding network and the first data codebook) on the first-apparatus side to update a network parameter. Accordingly, the first apparatus receives the intermediate result.

For example, the intermediate result is obtained by the second apparatus through computing based on the data reconstruction loss and the decoding network. The intermediate result may be gradient information, or may be intermediate information for determining the gradient information. This is not limited in this application.

S734: The first apparatus updates the first data reconstruction network based on the intermediate result.

For example, the first apparatus updates the second encoding network and the second data codebook based on the intermediate result, to obtain the first encoding network and the first data codebook.

Optionally, the first apparatus updates a local second encoding network and second data codebook based on a first loss function, to obtain the first encoding network and the first data codebook.

Optionally, if the first data reconstruction network and the first channel protection network are for communicating and recovering an intermediate feature extracted from the end-to-end network, and the initial configuration includes the testing sample label of the end-to-end network, the method 700 further includes the following steps.

S740: The first apparatus sends information about an index of the intermediate feature to the second apparatus, where the index that is of the intermediate feature and that can be determined based on the information about the index of the intermediate feature is obtained through processing based on the first encoding network and the first data codebook. Accordingly, the second apparatus receives the information about the index of the intermediate feature.

S750: The second apparatus determines whether the first data reconstruction network and/or the first channel protection network satisfy/satisfies a condition.

In a possible implementation, the second apparatus recovers, based on the first decoding network, the intermediate feature corresponding to the information about the index of the intermediate feature, inputs the intermediate feature into the end-to-end network to compute a result, and compares a distance (that is, a loss or performance of the end-to-end network) between the result and the testing sample label included in the initial configuration, to determine whether the distance satisfies the condition.

S760: The second apparatus sends feedback information to the first apparatus. Accordingly, the first apparatus receives the feedback information.

For example, if the loss of the end-to-end network satisfies the condition, that is, the loss of the end-to-end network is less than or equal to a third threshold (which may be predefined or preconfigured, or indicated by using signaling; and this is not limited in this application), the second apparatus sends the feedback information to the first apparatus, where the feedback information indicates that the first data reconstruction network and/or the first channel protection network satisfy/satisfies the condition; and the first apparatus no longer continues training. Subsequent data transmission may be processed based on the first data reconstruction network and/or the first channel protection network.

If the loss of the end-to-end network does not satisfy the condition, that is, the loss of the end-to-end network is greater than a specified third threshold, the second apparatus sends the feedback information to the first apparatus, where the feedback information indicates that the first data reconstruction network and/or the first channel protection network do/does not satisfy the condition. The second apparatus receives the feedback information, and continues to train the first data reconstruction network and/or the first channel protection network (S720 to S725 and/or S730 and S734 are repeated) until the condition is satisfied. The feedback information may further indicate the first apparatus to continue to train the first data reconstruction network, indicate the first apparatus to continue to train the first channel protection network, or indicate the first apparatus to continue to train the first data reconstruction network and the first channel protection network.

Alternatively, there is another solution parallel to S740+S750+S760. To be specific, the first apparatus may determine whether the trained first data reconstruction network and/or first channel protection network satisfy/satisfies the condition. A determining method is similar to the foregoing determining method of the second apparatus. Details are not described again.

In the method 700, a real channel state may be detected through real-time interaction, so that the data reconstruction network and/or the channel protection network obtained through training according to the method 700 better adapt/adapts to a real channel condition.

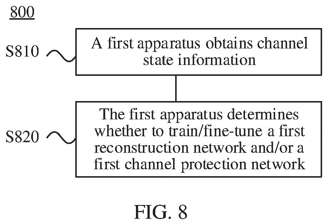

FIG. 8 is a schematic flowchart of periodically training and updating a data task network (a data reconstruction network is used as an example) and/or a channel protection network according to an embodiment of this application. An initiator of a periodic-training process may be a first apparatus, or may be a second apparatus. This is not limited in this embodiment of this application. FIG. 8 shows, as an example, a method 800 used by the first apparatus to periodically obtain channel state information and update a network at a first-apparatus end and a second-apparatus end. Others may be deduced by analogy, and are not listed one by one. The method 800 includes the following steps.

S810: The first apparatus obtains the channel state information.

For example, the first apparatus and the second apparatus have completed training of a first data reconstruction network and/or a first channel protection network according to the method 600 or 700 during time T. Assuming that the first apparatus is a terminal device, and the second apparatus is a network device, the first apparatus obtains the channel state information during time 2T, that is, the first apparatus sends a channel measurement sequence to the second apparatus during the time 2T (the channel measurement sequence may be sent via a signal such as an SRS, and the first apparatus may send the channel measurement sequence via the CSI in a case of an uplink-downlink symmetric channel), and the second apparatus feeds back uplink channel state information to the first apparatus after obtaining the channel state information through measurement based on the channel measurement sequence.

S820: The first apparatus determines whether to train/fine-tune the first data reconstruction network and/or the first channel protection network.

For example, the first apparatus compares a fluctuation status of a channel based on the channel state information obtained during the time 2T and channel state information that is during the time T. If a fluctuation is less than or equal to a specific threshold, the first data reconstruction network and/or the first channel protection network do/does not need to be retrained/fine-tuned. If a fluctuation is greater than a specific threshold, the first data reconstruction network and/or the first channel protection network need/needs to be retrained/fine-tuned. For a specific training method, refer to the methods 600 and 700. Details are not described herein again.

The first apparatus may perform S810 and S820 once at an interval of the time T. In other words, a periodicity in which the first apparatus trains and updates the first data reconstruction network and/or the first channel protection network is T.

Alternatively, if an end-to-end network is deployed on a first-apparatus side and a second-apparatus side, in addition to the method 800, the first apparatus may periodically (a periodicity may be T) send one batch of test set data to the second apparatus, and the second apparatus may determine a current channel condition based on performance that is of the end-to-end network and that is computed based on the batch of test set data.

For example, if the performance that is of the end-to-end network and that is computed by the second apparatus based on the batch of test set data is less than or equal to a specific threshold, the second apparatus determines that the current channel state (the time 2T) fluctuates more slightly compared with a previous channel state (the time T), and there is no need to retrain/fine-tune the first data reconstruction network and/or the first channel protection network. If the performance that is of the end-to-end network and that is computed by the second apparatus based on the batch of test set data is greater than a specific threshold, the second apparatus determines that the current channel state (the time 2T) fluctuates more greatly compared with a previous channel state (the time T), and there is a need to retrain/fine-tune the first data reconstruction network and/or the first channel protection network. For a specific training method, refer to the methods 600 and 700. Details are not described herein again.

The first data reconstruction network and/or the first channel protection network tuned based on a periodic channel state test better adapt/adapts to an environment in which a channel changes.

With reference to simulation instances, the following describes beneficial effects of using the communication methods provided in this application.

Solution 1: a combination of a data reconstruction network and an analog-noise layer, for example, a variational autoencoder (variation autoencoder, VAE) joint source and channel coding (joint source and channel coding, JSCC) analog (analog).

Solution 2: a combination of a data reconstruction network and conventional polar channel protection, for example, a digital single-codebook (digital single-codebook)+polar.

Solution 3: a combination of a data reconstruction network and a channel protection network, for example, digital double-codebook (digital double-codebook) JSCC.

Performance comparison between the foregoing three solutions with different compression rates and different signal-to-noise ratios is simulated. The compression rates are 6x and 12x. In addition, for the solution 1, two training signal-to-noise ratios (signal-to-noise ratios, SNRs) are set: -4 dB and 8 dB. For the solution 2, two training SNRs are set: 6 dB, 7 dB, and 8 dB (6x is optional). For the solution 3, three training SNRs are set: -4 dB, 2 dB, and 8 dB.

Baseline (baseline): end to end (end to end, E2E) 0.778 (which may be identification accuracy of an end to end network); E2E+a data network (6x): 0.773; and E2E+a data network (12x): 0.7683.

Generalized compression rate: a quantity of integer values of an original intermediate feature (for example, a quantity of pixel values of a feature map, where the quantity of pixel values may be c1*a1*b1 if dimensions of the intermediate feature are (c1, a1, b1))/a quantity of modulation symbols (a floating-point value, namely, a float, is mapped to the modulation symbol in an analog solution, and a bit value is mapped to the modulation symbol in a digital solution).

6x: m=8, and Rate=0.5; and 12x: m=7, and Rate=0.4375, where m represents a length of a bit sequence, and the bit sequence represents an index value corresponding to each piece of data in a codebook. The rate is a channel code rate (an input/an output obtained through processing based on a channel protection network), and represents a ratio of a length of each index bit sequence to a length of a bit sequence in a channel codebook.

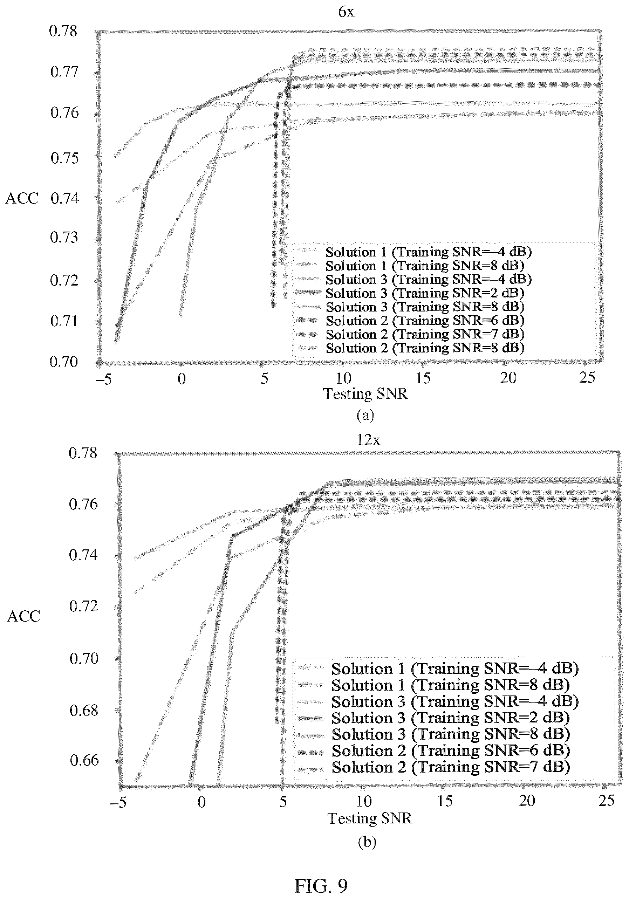

FIG. 9 shows simulation results of the foregoing three solutions under different conditions. (a) in FIG. 9 shows simulation results with a compression rate of 6x. (b) in FIG. 9 shows simulation results with a compression rate of 12x. A horizontal coordinate is a testing SNR. A vertical coordinate is accuracy (accuracy, ACC), and may represent performance. Higher ACC indicates better performance.

The following can be learned from FIG. 9:
The foregoing three solutions are compared. When a channel condition is better, two digital solutions (namely, the solution 2 and the solution 3) are superior to an analog solution (namely, the solution 1). When a channel condition is poorer, the solution 3 can maintain better performance, and performance of the solution 3 even may be close to performance of the solution 1.

The foregoing two digital solutions are compared. Performance of the solution 2 is close to performance of solution 3 in a case of a high SNR, and an SNR operating range may be extended by approximately 4 to 6 dB in the solution 3 in a case of a low SNR. It can be learned that performance of the solution 3 provided in this application is better than performance of the other digital solution under a condition of the low signal-to-noise ratio, and the performance of the solution 3 is better than performance of the analog solution under a condition of the high signal-to-noise ratio.

For data, a length of a bit sequence that may be obtained by compressing a float value of data (2048*4*4) in the data reconstruction network provided in this application is 512 or 224 bits, and a length of a sequence obtained through compression performed through conventional source coding JPEG/quantization and entropy encoding is far greater than 512 bits. Therefore, the data reconstruction network provided in this application can achieve a better compression effect, transmission bit overheads are reduced, and good performance can be further maintained based on a higher compression rate. In a case of a same compression rate, performance in this solution is better than performance in the conventional source coding JPEG/quantization and entropy encoding.

The dashed-line steps in the foregoing flowcharts are optional steps, and a sequence of the steps is determined based on internal logic of the method. The sequence numbers shown in the foregoing flowcharts are merely examples, and do not limit a sequence of the steps in this application.

It should be further understood that the methods provided in embodiments of this application may be separately used, or may be used in combination. This is not limited in this application. Various implementations provided in embodiments of this application may be separately used, or may be used in combination. This is not limited in this application.

It should be understood that the term "and/or" in this application describes only an association relationship between associated objects and represents that three relationships may exist. For example, A and/or B may represent the following three cases: only A exists, both A and B exist, and only B exists. A and B may be singular or plural. In addition, the character "/" in this specification usually represents an "or" relationship between the associated objects, or may represent an "and/or" relationship. A specific meaning depends on a context.

In this application, "at least one" means one or more, and "at least two" and "a plurality of" mean two or more. "At least one of the following" or a similar expression thereof refers to any combination of these items, including a singular item or any combination of plural items. For example, at least one of a, b, or c may indicate: a, b, c, a and b, a and c, b and c, or a, b, and c, where a, b, and c may be singular or plural.

It should be noted that the execution body shown in FIG. 2 and FIG. 6 to FIG. 8 is merely an example, and the execution body may alternatively be a chip, a chip system, or a processor that supports the execution body in implementing the methods shown in FIG. 2 and FIG. 6 to FIG. 8. This is not limited in this application.

The foregoing describes the method embodiments in embodiments of this application with reference to the accompanying drawings. The following describes apparatus embodiments in embodiments of this application. It may be understood that the descriptions of the method embodiments and the descriptions of the apparatus embodiments may correspond to each other. Therefore, for a part that is not described, refer to the foregoing method embodiments.

It may be understood that, in the foregoing method embodiments, the method and the operation implemented by the first apparatus may alternatively be implemented by a component (for example, a chip or a circuit) in the first apparatus, and the method and the operation implemented by the second apparatus may alternatively be implemented by a component (for example, a chip or a circuit) in the second apparatus.

The foregoing mainly describes the solutions provided in embodiments of this application from a perspective of interaction between the network elements. It may be understood that, to implement the foregoing functions, each network element such as a transmitting end device or a receiving end device includes a corresponding hardware structure and/or software module for performing each function. A person skilled in the art should be able to be aware that, with reference to the units and algorithm steps in the examples described in embodiments disclosed in this specification, this application can be implemented by hardware or a combination of hardware and computer software. Whether a function is performed by hardware or hardware driven by computer software depends on particular applications and design constraints of the technical solutions. A person skilled in the art may use different methods to implement the functions for each particular application, but it should not be considered that the implementation goes beyond the scope of this application.

In embodiments of this application, a transmitting end device or a receiving end device may be divided into functional modules based on the foregoing method examples. For example, each functional module may be obtained through division corresponding to each function, or two or more functions may be integrated in one processing module. The integrated module may be implemented in a form of hardware, or may be implemented in a form of a software functional module. It should be noted that, in embodiments of this application, division into the modules is an example, and is merely logical function division. Another division manner may be used during actual implementation. An example in which each functional module is obtained through division corresponding to each function is used below for description.

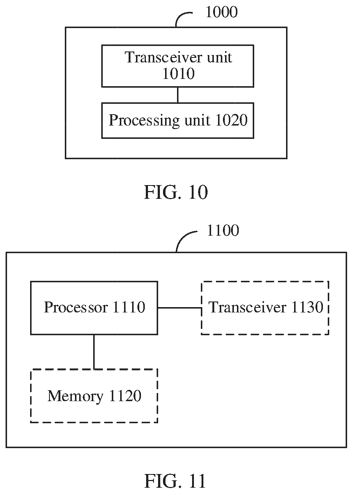

FIG. 10 is a schematic block diagram of a communication apparatus according to an embodiment of this application. The communication apparatus 1000 shown in FIG. 10 includes a transceiver unit 1010 and a processing unit 1020. The transceiver unit 1010 may communicate with the outside, and the processing unit 1020 is configured to process data. The transceiver unit 1010 may also be referred to as a communication interface or a communication unit.

Optionally, the transceiver unit 1010 may include a sending unit and a receiving unit. The sending unit is configured to perform a sending operation in the foregoing method embodiments. The receiving unit is configured to perform a receiving operation in the foregoing method embodiments.

It should be noted that the communication apparatus 1000 may include the sending unit, but does not include the receiving unit. Alternatively, the communication apparatus 1000 may include the receiving unit, but does not include the sending unit. This may specifically depend on whether the foregoing solution performed by the communication apparatus 1000 includes a sending action and a receiving action.

Optionally, the communication apparatus 1000 may further include a storage unit. The storage unit may be configured to store instructions and/or data. The processing unit 1020 may read the instructions and/or the data in the storage unit.

In a design, the communication apparatus 1000 may be configured to perform actions performed by the first apparatus in the foregoing method embodiments.

Optionally, the communication apparatus 1000 may be the first apparatus. The transceiver unit 1010 is configured to perform a receiving or sending operation of the first apparatus in the foregoing method embodiments. The processing unit 1020 is configured to perform an internal processing operation of the first apparatus in the foregoing method embodiments.

Optionally, the communication apparatus 1000 may be a device including the first apparatus. Alternatively, the communication apparatus 1000 may be a component configured in the first apparatus, for example, a chip in the first apparatus. In this case, the transceiver unit 1010 may be an interface circuit, a pin, or the like. Specifically, the interface circuit may include an input circuit and an output circuit, and the processing unit 1020 may include a processing circuit.

In a possible implementation, the processing unit 1020 is configured to: obtain data; and determine an index of the data based on a first encoding network and a first data codebook, where the first encoding network is for encoding the data, and the first data codebook includes a correspondence between encoded data and the index. The transceiver unit 1010 sends information about the index of the data.

In a possible implementation, the processing unit 1020 is further configured to: process the index of the data based on a first information protection network, to obtain a floating-point sequence; and further process the floating-point sequence to obtain a bit sequence. The transceiver unit 1010 is further configured to send the bit sequence.

In a possible implementation, the processing unit 1020 is further configured to determine, based on a first channel codebook, a bit sequence corresponding to the index of the data. The transceiver unit 1010 is further configured to send the bit sequence, where the first channel codebook includes a correspondence between the index of the data and the bit sequence.

In a possible implementation, the processing unit 1020 or the transceiver unit 1010 is further configured to obtain the first encoding network and the first data codebook.

In a possible implementation, the processing unit 1020 or the transceiver unit 1010 is further configured to obtain the first information protection network or the first channel codebook.

In a possible implementation, the first information protection network is obtained through training based on channel state information and an index of data, where the index of the data is obtained based on a second encoding network and a second data codebook.

In a possible implementation, the first information protection network is obtained through training based on channel state information, an index of training data, and a loss function, where the loss function is associated with at least one of a codeword distance loss, an information reconstruction loss, and a sequence distance loss. The codeword distance loss is a loss of a distance between a first floating-point sequence and a second floating-point sequence, the first floating-point sequence is obtained by processing a first index based on a second information protection network, and the second floating-point sequence is obtained by processing a second index based on the second information protection network. The information reconstruction loss is a loss of a distance between a third index on which processing has not been performed based on the second information protection network and a third index obtained through processing based on a second information recovery network, and the second information recovery network corresponds to the second information protection network. The sequence distance loss is a loss of a distance between a floating-point sequence and a bit sequence, the floating-point sequence is obtained through processing based on the second information protection network, the bit sequence is a bit sequence included in a second channel codebook, and the second channel codebook is the first channel codebook that has not been updated. The second information protection network is a first information protection network that has not been updated, the first index, the second index, and the third index are obtained based on a second encoding network and a second data codebook, the second encoding network is the first encoding network that has not been updated, and the second data codebook is the first data codebook that has not been updated.

In a possible implementation, the first encoding network and the first data codebook are obtained through training based on training data, a first channel protection network, channel state information, a second encoding network, and a second data codebook, where the first channel protection network includes a first information protection network, a first channel codebook, and a first information recovery network, and the first information recovery network corresponds to the first information protection network.

In a possible implementation, a length of a codeword in the first data codebook and a quantity of codewords in the first data codebook are associated with a dimension of the encoded data.

In a possible implementation, the data is an intermediate feature, and the quantity of codewords is associated with at least one of the following: a compression rate of a data task network, a storage resource of the first apparatus, and performance of the data task network.

In a possible implementation, the data task network is a first data reconstruction network, the first data reconstruction network includes at least one of the first encoding network, the first data codebook, and a first decoding network, and the first encoding network corresponds to the first decoding network.

In a possible implementation, the transceiver unit 1010 is further configured to send a first decoding network parameter and first data codebook information, where the first decoding network determined based on the first decoding network parameter corresponds to the first encoding network, and the first data codebook information is for determining the first data codebook.

In a possible implementation, the transceiver unit 1010 is further configured to send a second decoding network parameter and second data codebook information, where a second decoding network determined based on the second decoding network parameter is for training to obtain the first decoding network, the first decoding network corresponds to the first encoding network, and the second data codebook information is for determining the second data codebook.

In a possible implementation, the transceiver unit 1010 is further configured to send a first information recovery network parameter, where the first information recovery network determined based on the first information recovery network parameter corresponds to the first information protection network.

In a possible implementation, the transceiver unit 1010 is further configured to send a second information recovery network parameter, where the second information recovery network determined based on the second information recovery network parameter is for training to obtain the first information recovery network, and the first information recovery network corresponds to the first information protection network.

In another design, the communication apparatus 1000 shown in FIG. 10 may be configured to perform actions performed by the second apparatus in the foregoing method embodiments.

Optionally, the communication apparatus 1000 may be the second apparatus. The transceiver unit 1010 is configured to perform a receiving or sending operation of the second apparatus in the foregoing method embodiments. The processing unit 1020 is configured to perform an internal processing operation of the second apparatus in the foregoing method embodiments.

Optionally, the communication apparatus 1000 may be a device including the second apparatus. Alternatively, the communication apparatus 1000 may be a component configured in the second apparatus, for example, a chip in the second apparatus. In this case, the transceiver unit 1010 may be an interface circuit, a pin, or the like. Specifically, the interface circuit may include an input circuit and an output circuit, and the processing unit 1020 may include a processing circuit.

In a possible implementation, the transceiver unit 1010 is configured to receive information about an index of data, where the information about the index of the data is for determining the index of the data. The processing unit 1020 is configured to determine, based on a first data codebook, encoded data corresponding to the index of the data, where the first data codebook includes a correspondence between the encoded data and the index.

In a possible implementation, the transceiver unit 1010 is further configured to receive a bit sequence. The processing unit 1020 is further configured to process the bit sequence based on a first information recovery network, to obtain the index of the data.

In a possible implementation, the processing unit 1020 is further configured to decode the encoded data based on a first decoding network, to obtain decoded data.

In a possible implementation, the transceiver unit 1010 or the processing unit 1020 is further configured to obtain the first decoding network and the first data codebook.

In a possible implementation, the transceiver unit 1010 or the processing unit 1020 is configured to obtain the first information recovery network.

In a possible implementation, the first information recovery network is obtained through training based on channel state information and an index of training data, where the index of the training data is obtained based on a second encoding network and a second data codebook.

In a possible implementation, the first information recovery network is obtained through training based on uplink channel state information, an index of training data, and a loss function, where the loss function is associated with at least one of a codeword distance loss, an information reconstruction loss, and a sequence distance loss. The codeword distance loss is a loss of a distance between a first floating-point sequence and a second floating-point sequence, the first floating-point sequence is obtained by processing a first index based on a second information protection network, and the second floating-point sequence is obtained by processing a second index based on the second information protection network. The information reconstruction loss is a loss of a distance between a third index on which processing has not been performed based on the second information protection network and a third index obtained through processing based on a second information recovery network, and the second information recovery network corresponds to the second information protection network. The sequence distance loss is a loss of a distance between a floating-point sequence and a bit sequence, the floating-point sequence is obtained through processing based on the second information protection network, the bit sequence is a bit sequence included in a second channel codebook, and the second channel codebook is a first channel codebook that has not been updated. The second information protection network is the first information protection network that has not been updated, the first index, the second index, and the third index are obtained based on a second encoding network and a second data codebook, the second encoding network is a first encoding network that has not been updated, and the second data codebook is the first data codebook that has not been updated. In a possible implementation, the first decoding network and the first data codebook are obtained through training based on the data, the channel state information, a first channel protection network, the second encoding network, and the second data codebook, where the first channel protection network includes a first information protection network, the first channel codebook, and the first information recovery network, and the first information recovery network corresponds to the first information protection network.

In a possible implementation, a length of a codeword in the first data codebook and a quantity of codewords in the first data codebook are associated with a dimension of the encoded data.

In a possible implementation, the data is an intermediate feature, and the quantity of codewords is associated with at least one of the following: a compression rate of a data task network, a storage resource of the second apparatus, and performance of the data task network.

In a possible implementation, the data task network is a first data reconstruction network, the first data reconstruction network includes at least one of a first encoding network, the first data codebook, and the first decoding network, and the first encoding network corresponds to the first decoding network.

In a possible implementation, the transceiver unit 1010 is further configured to receive a first decoding network parameter and first data codebook information, where the first decoding network parameter and the first data codebook information are for determining the first decoding network and the first data codebook.

In a possible implementation, the transceiver unit 1010 is further configured to receive a second decoding network parameter and second data codebook information, where the second decoding network parameter is for determining a second decoding network, the second data codebook information is for determining the second data codebook, and the second decoding network and the second data codebook are for training to obtain the first decoding network and the first data codebook.

In a possible implementation, the transceiver unit 1010 is further configured to receive a first information recovery network parameter, where the first information recovery network parameter is for determining the first information recovery network.

In a possible implementation, the transceiver unit 1010 is further configured to receive a second information recovery network parameter, where the second information recovery network determined based on the second information recovery network parameter is for training to obtain the first information recovery network.

As shown in FIG. 11, an embodiment of this application further provides a communication apparatus 1100. The communication apparatus 1100 includes a processor 1110. The processor 1110 is coupled to a memory 1120. The memory 1120 is configured to store a computer program or instructions and/or data. The processor 1110 is configured to execute the computer program or the instructions and/or the data stored in the memory 1120, so that the methods in the foregoing method embodiments are performed.

Optionally, the communication apparatus 1100 includes one or more processors 1110.

Optionally, as shown in FIG. 11, the communication apparatus 1100 may further include the memory 1120.

Optionally, the communication apparatus 1100 may include one or more memories 1120.

Optionally, the memory 1120 and the processor 1110 may be integrated together or separately disposed.

Optionally, as shown in FIG. 11, the communication apparatus 1100 may further include a transceiver 1130 and/or a communication interface. The transceiver 1130 and/or the communication interface are/is configured to receive and/or send a signal. For example, the processor 1110 is configured to control the transceiver 1130 and/or the communication interface to receive and/or send the signal.

Optionally, a component configured to implement a receiving function in the transceiver 1130 may be considered as a receiving module, and a component configured to implement a sending function in the transceiver 1130 may be considered as a sending module. That is, the transceiver 1130 includes a receiver and a transmitter. The transceiver may also be sometimes referred to as a transceiver module, a transceiver circuit, or the like. The receiver may also be sometimes referred to as a receiving module, a receiving circuit, or the like. The transmitter may also be sometimes referred to as a transmitting module, a transmitting circuit, or the like.

In a solution, the communication apparatus 1100 is configured to implement operations performed by the first apparatus in the foregoing method embodiments. For example, the processor 1110 is configured to implement operations (for example, operations in S210, S220, S410, S420, S430, S510, S520, S530, S620, S630, S720, S725, S730, S734, S810, and S820) internally performed by the first apparatus in the foregoing method embodiments, and the transceiver 1130 is configured to implement receiving or sending operations (for example, operations in S230, S230', S610, S640, S650, S670, S710, S721, S722, S724, S731, S733, S740, and S760) performed by the first apparatus in the foregoing method embodiments.

In a solution, the communication apparatus 1100 is configured to implement operations performed by the second apparatus in the foregoing method embodiments. For example, the processor 1110 is configured to implement operations (for example, operations in S240, S250, S410, S420, S430, S510, S520, S530, S660, S723, S732, S750, S810, and S820) internally performed by the second apparatus in the foregoing method embodiments, and the transceiver 1130 is configured to implement receiving or sending operations (for example, operations in S230, S230', S610, S640, S650, S670, S710, S721, S722, S724, S731, S733, S740, and S760) performed by the second apparatus in the foregoing method embodiments.

An embodiment of this application further provides a communication apparatus 1200. The communication apparatus 1200 may be a terminal device or a network device, or may be a chip in the terminal device or the network device. The communication apparatus 1200 may be configured to perform operations performed by the first apparatus or the second apparatus in the foregoing method embodiments.

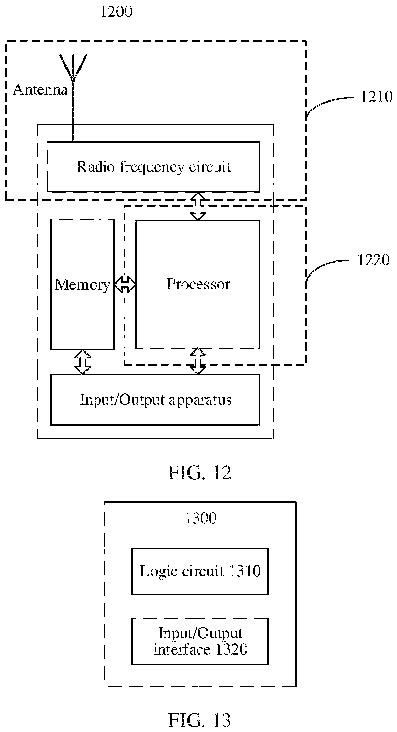

FIG. 12 is a diagram of a simplified structure of a communication apparatus. As shown in FIG. 12, the communication apparatus 1200 includes a processor, a memory, a radio frequency circuit, an antenna, and an input/output apparatus. The processor is mainly configured to: process a communication protocol and communication data, control the communication apparatus 1200, execute a software program, process data of the software program, and so on. The memory is mainly configured to store the software program and the data. The radio frequency circuit is mainly configured to perform conversion between a baseband signal and a radio frequency signal, and process the radio frequency signal. The antenna is mainly configured to send and receive a radio frequency signal in a form of an electromagnetic wave. The input/output apparatus, such as a touchscreen, a display, or a keyboard, is mainly configured to: receive data entered by a user, and output data to the user.

When data needs to be sent, the processor performs baseband processing on the to-be-sent data, and outputs a baseband signal to the radio frequency circuit. After performing radio frequency processing on the baseband signal, the radio frequency circuit sends a radio frequency signal in a form of an electromagnetic wave through the antenna. When data is sent to the communication apparatus 1200, the radio frequency circuit receives a radio frequency signal through the antenna, converts the radio frequency signal into a baseband signal, and outputs the baseband signal to the processor. The processor converts the baseband signal into data, and processes the data. For ease of description, FIG. 12 shows only one memory and one processor. In an actual product, there may be one or more processors and one or more memories. The memory may also be referred to as a storage medium, a storage device, or the like. The memory may be disposed independent of the processor, or may be integrated with the processor. This is not limited in this embodiment of this application.

In this embodiment of this application, the antenna and the radio frequency circuit that have a transceiver function may be considered as a transceiver unit of the communication apparatus 1200, and the processor that has a processing function may be considered as a processing unit of the communication apparatus 1200.

As shown in FIG. 12, the communication apparatus 1200 includes a transceiver unit 1210 and a processing unit 1220. The transceiver unit 1210 may also be referred to as a transceiver, a transceiver apparatus, a transceiver circuit, or the like. The processing unit 1220 may also be referred to as a processor, a processing board, a processing module, a processing apparatus, or the like.

Optionally, a component configured to implement a receiving function in the transceiver unit 1210 may be considered as a receiving unit, and a component configured to implement a sending function in the transceiver unit 1210 may be considered as a sending unit. That is, the transceiver unit 1210 includes the receiving unit and the sending unit. The receiving unit may also be sometimes referred to as a receiver, a receiving apparatus, a receiving circuit, or the like. The sending unit may also be sometimes referred to as a transmitter, a transmitting apparatus, a transmitting circuit, or the like.

In an implementation, the processing unit 1220 and the transceiver unit 1210 are configured to perform operations on a first-apparatus side.

For example, the processing unit 1220 is configured to perform operations in S210, S220, S410, S420, S430, S510, S520, S530, S620, S630, S720, S725, S730, S734, S810, and S820. The transceiver unit 1210 is configured to perform receiving and sending operations in S230, S230', S610, S640, S650, S670, S710, S721, S722, S724, S731, S733, S740, and S760.

In another implementation, the processing unit 1220 and the transceiver unit 1210 are configured to perform operations on a second-apparatus side.

For example, the processing unit 1220 is configured to perform operations in S240, S250, S410, S420, S430, S510, S520, S530, S660, S723, S732, S750, S810, and S820. The transceiver unit 1210 is configured to perform receiving and sending operations in S230, S230', S610, S640, S650, S670, S710, S721, S722, S724, S731, S733, S740, and S760.

It should be understood that FIG. 12 is merely an example instead of a limitation. The communication apparatus 1200 including the transceiver unit and the processing unit may not depend on the structure shown in FIG. 12.

When the communication apparatus 1200 is a chip, the chip includes a transceiver unit and a processing unit. The transceiver unit may be an input/output circuit or a communication interface. The processing unit may be a processor, a microprocessor, or an integrated circuit that is integrated on the chip.

As shown in FIG. 13, an embodiment of this application further provides a communication apparatus 1300. The communication apparatus 1300 includes a logic circuit 1310 and an input/output interface (input/output interface) 1320.

The logic circuit 1310 may be a processing circuit in the communication apparatus 1300. The logic circuit 1310 may be coupled and connected to a storage unit, and invoke instructions in the storage unit, so that the communication apparatus 1300 can implement the methods and functions in embodiments of this application. The input/output interface 1320 may be an input/output circuit in the communication apparatus 1300, and outputs information processed by the communication apparatus 1300, or inputs to-be-processed data or signaling information into the communication apparatus 1300 for processing.

In a solution, the communication apparatus 1300 is configured to implement operations performed by the first apparatus in the foregoing method embodiments.

For example, the logic circuit 1310 is configured to implement processing-related operations performed by the first apparatus in the foregoing method embodiments, for example, configured to implement processing operations in S210, S220, S410, S420, S430, S510, S520, S530, S620, S630, S720, S725, S730, S734, S810, and S820. The input/output interface 1320 is configured to implement operations related to sending and/or receiving and performed by the first apparatus in the foregoing method embodiments, for example, receiving and sending operations of the first apparatus in S230, S230', S610, S640, S650, S670, S710, S721, S722, S724, S731, S733, S740, and S760. For specific operations performed by the logic circuit 1310, refer to the foregoing descriptions of the processing unit 1020. For operations performed by the input/output interface 1320, refer to the foregoing descriptions of the transceiver unit 1010. Details are not described herein again.

In another solution, the communication apparatus 1300 is configured to implement operations performed by the second apparatus in the foregoing method embodiments.

For example, the logic circuit 1310 is configured to implement processing-related operations performed by the second apparatus in the foregoing method embodiments, for example, processing-related operations performed by the second apparatus in the method embodiments. The input/output interface 1320 is configured to implement operations related to sending and/or receiving and performed by the second apparatus in the foregoing method embodiments, for example, receiving and sending operations of the second apparatus in S230, S230', S610, S640, S650, S670, S710, S721, S722, S724, S731, S733, S740, and S760. For specific operations performed by the logic circuit 1310, refer to the foregoing descriptions of the processing unit 920, for example, processing operations of the second apparatus in S240, S250, S410, S420, S430, S510, S520, S530, S660, S723, S732, S750, S810, and S820. For specific operations performed by the logic circuit 1310, refer to the foregoing descriptions of the processing unit 1020. For operations performed by the input/output interface 1320, refer to the foregoing descriptions of the transceiver unit 1010. Details are not described herein again.

It should be understood that the communication apparatus may be one or more chips. For example, the communication apparatus may be a field programmable gate array (field programmable gate array, FPGA), an application specific integrated chip (application specific integrated circuit, ASIC), a system on chip (system on chip, SoC), a central processing unit (central processing unit, CPU), a network processor (network processor, NP), a digital signal processing circuit (digital signal processor, DSP), a micro controller unit (micro controller unit, MCU), a programmable controller (programmable logic device, PLD), or another integrated chip.

In an implementation process, the steps in the foregoing methods may be completed through an integrated logic circuit of hardware in the processor, or by using instructions in a form of software. The steps in the methods disclosed with reference to embodiments of this application may be directly performed and completed by a hardware processor, or may be performed and completed by using a combination of hardware in the processor and a software module. The software module may be located in a mature storage medium in the art, for example, a random access memory, a flash memory, a read-only memory, a programmable read-only memory, an electrically erasable programmable memory, or a register. The storage medium is located in a memory. The processor reads information in the memory, and completes the steps in the foregoing methods in combination with hardware of the processor. To avoid repetition, details are not described herein again.

It should be noted that the processor in embodiments of this application may be an integrated circuit chip, and has a signal processing capability. In an implementation process, the steps in the foregoing method embodiments may be completed through the integrated logic circuit of the hardware in the processor, or by using the instructions in the form of the software. The processor may be a general-purpose processor, a digital signal processor (DSP), an application specific integrated circuit (ASIC), a field programmable gate array (FPGA) or another programmable logic device, a discrete gate or a transistor logic device, or a discrete hardware component. The processor may implement or perform the methods, the steps, and the logical block diagrams that are disclosed in embodiments of this application. The general-purpose processor may be a microprocessor, or the processor may be any conventional processor or the like. The steps in the methods disclosed with reference to embodiments of this application may be directly performed and completed by a hardware decoding processor, or may be performed and completed by using a combination of hardware in a decoding processor and a software module. The software module may be located in a mature storage medium in the art, for example, a random access memory, a flash memory, a read-only memory, a programmable read-only memory, an electrically erasable programmable memory, or a register. The storage medium is located in a memory. The processor reads information in the memory, and completes the steps in the foregoing methods in combination with hardware of the processor.

It may be understood that the memory in embodiments of this application may be a volatile memory or a nonvolatile memory, or may include a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM) that is used as an external cache. By way of example but not limitative description, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM). It should be noted that the memory in the system and the methods in this specification aims to include, but not limited to, these and any memory of another appropriate type.

According to the method provided in embodiments of this application, this application further provides a computer-readable medium. The computer-readable medium stores program code. When the program code is run on a computer, the computer is enabled to perform the method shown in the method embodiment. For example, when a computer program is executed by the computer, the computer is enabled to implement the method performed by the first apparatus or the method performed by the second apparatus in the foregoing method embodiment.

An embodiment of this application further provides a computer program product including instructions. When the instructions are executed by a computer, the computer is enabled to implement the method performed by the first apparatus or the method performed by the second apparatus in the foregoing method embodiment.

For explanations and beneficial effects of related content in any communication apparatus provided above, refer to the foregoing corresponding method embodiments. Details are not described herein again.

All or some of the foregoing embodiments may be implemented by using software, hardware, firmware, or any combination thereof. When the software is used to implement embodiments, all or some of embodiments may be implemented in a form of a computer program product. The computer program product includes one or more computer instructions. When the computer instructions are loaded and executed on a computer, the procedures or functions according to embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), an optical medium (for example, a digital video disc (digital video disc, DVD)), a semiconductor medium (for example, a solid-state drive (solid-state drive, SSD)), or the like.

The first apparatus and the second apparatus in the foregoing apparatus embodiments correspond to the first apparatus and the second apparatus in the method embodiments, and corresponding modules or units perform corresponding steps. For example, a communication unit (a transceiver) performs a receiving or sending step in the method embodiments. A step other than sending and receiving may be performed by a processing unit (a processor). For a function of a specific unit, refer to a corresponding method embodiment. There may be one or more processors.

Terms such as "component", "module", and "system" used in this specification indicate computer-related entities, hardware, firmware, combinations of hardware and software, software, or software being executed. For example, a component may be, but is not limited to, a process that runs on a processor, a processor, an object, an executable file, an execution thread, a program, and/or a computer. As illustrated by using figures, both a computing device and an application that runs on the computing device may be components. One or more components may reside within a process and/or an execution thread, and a component may be located on one computer and/or distributed between two or more computers. In addition, these components may be executed by various computer-readable media that store various data structures. For example, the components may communicate by using a local and/or remote process based on a signal having one or more data packets (for example, data from two components interacting with another component in a local system, in a distributed system, and/or across a network such as the internet interacting with another system by using the signal).

A person of ordinary skill in the art can be aware that, with reference to the units and algorithm steps in the examples described in embodiments disclosed in this specification, this application can be implemented by electronic hardware or a combination of computer software and electronic hardware. Whether the functions are performed by hardware or software depends on particular applications and design constraints of the technical solutions. A person skilled in the art may use different methods to implement the functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus, and method may be implemented in other manners. For example, the foregoing apparatus embodiment is merely an example. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or other forms.

The units described as separate parts may or may not be physically separate, and parts displayed as units may or may not be physical units, that is, may be located in one position, or may be distributed on a plurality of network units. Some or all of the units may be selected based on actual requirements to achieve the objectives of the solutions in embodiments.

In addition, functional units in embodiments of this application may be integrated into one processing unit, each of the units may exist alone physically, or two or more units may be integrated into one unit.

When the functions are implemented in the form of a software functional unit and sold or used as an independent product, the functions may be stored in a computer-readable storage medium. Based on such an understanding, the technical solutions in this application essentially, the part contributing to the conventional technology, or some of the technical solutions may be implemented in a form of a software product. The computer software product is stored in a storage medium, and includes several instructions for instructing a computer device (which may be a personal computer, a server, a network device, or the like) to perform all or some of the steps in the methods in embodiments of this application. The foregoing storage medium includes: various media that can store program code, such as a USB flash drive, a removable hard disk, a read-only memory (read-only memory, ROM), a random access memory (random access memory, RAM), a magnetic disk, or a compact disc.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A data transmission method, comprising:
obtaining, by a first apparatus, data;
determining, by the first apparatus, an index of the data based on a first encoding network and a first data codebook, wherein the first encoding network is for encoding the data, and the first data codebook comprises a correspondence between encoded data and the index; and
sending, by the first apparatus, information about the index of the data.

2. The method according to claim 1, wherein the first encoding network and the first data codebook are obtained through training based on training data, a first channel protection network, channel state information, a second encoding network, and a second data codebook, wherein the first channel protection network comprises a first information protection network, a first channel codebook, and a first information recovery network, and the first information recovery network corresponds to the first information protection network.

3. The method according to claim 2, wherein the information about the index of the data comprises a bit sequence, the bit sequence is obtained by processing a floating-point sequence, and the floating-point sequence is obtained by processing the index of the data based on the first information protection network.

4. The method according to claim 2, wherein the information about the index of the data comprises a bit sequence, the bit sequence is determined based on the first channel codebook and the index of the data, and the first channel codebook comprises a correspondence between the index of the data and the bit sequence.

5. The method according to any one of claims 1 to 4, wherein the method further comprises:
obtaining, by the first apparatus, the first encoding network and the first data codebook.

6. The method according to any one of claims 2 to 5, wherein the method further comprises:
obtaining, by the first apparatus, the first information protection network or the first channel codebook.

7. The method according to any one of claims 2 to 6, wherein the first information protection network is obtained through training based on the channel state information and an index of the training data, wherein the index of the training data is obtained based on the second encoding network and the second data codebook.

8. The method according to any one of claims 2 to 6, wherein the first information protection network is obtained through training based on the channel state information, an index of the training data, and a loss function, wherein the loss function is associated with at least one of a codeword distance loss, an information reconstruction loss, and a sequence distance loss.

9. The method according to any one of claims 1 to 8, wherein a length of a codeword in the first data codebook and a quantity of codewords in the first data codebook are associated with a dimension of the encoded data.

10. The method according to claim 9, wherein the quantity of codewords is associated with at least one of the following:
a compression rate of a data task network, a storage resource of the first apparatus, and performance of the data task network.

11. The method according to claim 10, wherein the data task network comprises at least one of the first encoding network, the first data codebook, and a first decoding network, and the first encoding network corresponds to the first decoding network.

12. The method according to any one of claims 1 to 11, wherein the method further comprises:
sending, by the first apparatus, a first decoding network parameter and first data codebook information, wherein the first decoding network determined based on the first decoding network parameter corresponds to the first encoding network, and the first data codebook information is for determining the first data codebook.

13. The method according to any one of claims 1 to 11, wherein the method further comprises:
sending, by the first apparatus, a second decoding network parameter and second data codebook information, wherein a second decoding network determined based on the second decoding network parameter is for training to obtain the first decoding network, the first decoding network corresponds to the first encoding network, and the second data codebook information is for determining the second data codebook.

14. The method according to any one of claims 2 to 13, wherein the method further comprises:
sending, by the first apparatus, a first information recovery network parameter, wherein the first information recovery network determined based on the first information recovery network parameter corresponds to the first information protection network.

15. The method according to any one of claims 2 to 13, wherein the method further comprises:
sending, by the first apparatus, a second information recovery network parameter, wherein a second information recovery network determined based on the second information recovery network parameter is for training to obtain the first information recovery network, and the first information recovery network corresponds to the first information protection network.

16. A data transmission method, comprising:
receiving, by a second apparatus, information about an index of data, wherein the information about the index of the data is for determining the index of the data; and
determining, by the second apparatus based on a first data codebook, encoded data corresponding to the index of the data, wherein the first data codebook comprises a correspondence between the encoded data and the index.

17. The method according to claim 16, wherein the information about the index of the data comprises a bit sequence, and the method further comprises:
processing, by the second apparatus, the bit sequence based on a first information recovery network, to obtain the index of the data.

18. The method according to claim 17, wherein the method further comprises:
obtaining, by the second apparatus, the first information recovery network.

19. The method according to claim 17 or 18, wherein the first information recovery network is obtained through training based on channel state information and an index of training data, wherein the index of the training data is obtained based on a second encoding network and a second data codebook.

20. The method according to claim 17 or 18, wherein the first information recovery network is obtained through training based on channel state information, an index of training data, and a loss function, wherein the loss function is associated with at least one of a codeword distance loss, an information reconstruction loss, and a sequence distance loss.

21. The method according to any one of claims 16 to 20, wherein the method further comprises:
decoding, by the second apparatus, the encoded data based on a first decoding network, to obtain decoded data.

22. The method according to claim 21, wherein the method further comprises:
obtaining, by the second apparatus, the first decoding network and the first data codebook.

23. The method according to claim 21 or 22, wherein the first decoding network and the first data codebook are obtained through training based on the training data, the channel state information, a first channel protection network, the second encoding network, and the second data codebook, wherein the first channel protection network comprises a first information protection network and the first information recovery network, and the first information recovery network corresponds to the first information protection network.

24. The method according to any one of claims 16 to 23, wherein a length of a codeword in the first data codebook and a quantity of codewords in the first data codebook are associated with a dimension of the encoded data.

25. The method according to claim 24, wherein the quantity of codewords is associated with at least one of the following:
a compression rate of a data task network, a storage resource of the second apparatus, and performance of the data task network.

26. The method according to claim 25, wherein the data task network comprises at least one of a first encoding network, the first data codebook, and the first decoding network, and the first encoding network corresponds to the first decoding network.

27. The method according to any one of claims 21 to 26, wherein the method further comprises:
receiving, by the second apparatus, a first decoding network parameter and first data codebook information, wherein the first decoding network parameter and the first data codebook information are for determining the first decoding network and the first data codebook.

28. The method according to any one of claims 21 to 26, wherein the method further comprises:
receiving, by the second apparatus, a second decoding network parameter and second data codebook information, wherein the second decoding network parameter is for determining a second decoding network, the second data codebook information is for determining the second data codebook, and the second decoding network and the second data codebook are for training to obtain the first decoding network and the first data codebook.

29. The method according to any one of claims 17 to 28, wherein the method further comprises:
receiving, by the second apparatus, a first information recovery network parameter, wherein the first information recovery network parameter is for determining the first information recovery network.

30. The method according to any one of claims 17 to 28, wherein the method further comprises:
receiving, by the second apparatus, a second information recovery network parameter, wherein a second information recovery network determined based on the second information recovery network parameter is for training to obtain the first information recovery network.

31. A data transmission apparatus, wherein the apparatus comprises:
a processing unit, configured to obtain data, wherein
the processing unit is further configured to determine an index of the data based on a first encoding network and a first data codebook, wherein the first encoding network is for encoding the data, and the first data codebook comprises a correspondence between encoded data and the index; and
a transceiver unit, configured to send information about the index of the data.

32. The apparatus according to claim 31, wherein the first encoding network and the first data codebook are obtained through training based on training data, a first channel protection network, channel state information, a second encoding network, and a second data codebook, wherein the first channel protection network comprises a first information protection network, a first channel codebook, and a first information recovery network, and the first information recovery network corresponds to the first information protection network.

33. The apparatus according to claim 32, wherein the processing unit is further configured to: process the index of the data based on the first information protection network, to obtain a floating-point sequence; and further process the floating-point sequence to obtain a bit sequence; and the transceiver unit is further configured to send the bit sequence.

34. The apparatus according to claim 32, wherein the processing unit is further configured to determine, based on the first channel codebook, a bit sequence corresponding to the index of the data, and the transceiver unit is further configured to send the bit sequence, wherein the first channel codebook comprises a correspondence between the index of the data and the bit sequence.

35. The apparatus according to any one of claims 31 to 34, wherein the processing unit or the transceiver unit is further configured to obtain the first encoding network and the first data codebook.

36. The apparatus according to any one of claims 32 to 35, wherein the processing unit or the transceiver unit is further configured to obtain the first information protection network or the first channel codebook.

37. The apparatus according to any one of claims 32 to 36, wherein the first information protection network is obtained through training based on the channel state information and an index of the training data, wherein the index of the training data is obtained based on the second encoding network and the second data codebook.

38. The apparatus according to any one of claims 32 to 36, wherein the first information protection network is obtained through training based on the channel state information, an index of the training data, and a loss function, wherein the loss function is associated with at least one of a codeword distance loss, an information reconstruction loss, and a sequence distance loss.

39. The apparatus according to any one of claims 31 to 38, wherein a length of a codeword in the first data codebook and a quantity of codewords in the first data codebook are associated with a dimension of the encoded data.

40. The apparatus according to claim 39, wherein the quantity of codewords is associated with at least one of the following:
a compression rate of a data task network, a storage resource of the first apparatus, and performance of the data task network.

41. The apparatus according to claim 40, wherein the data task network comprises at least one of the first encoding network, the first data codebook, and a first decoding network, and the first encoding network corresponds to the first decoding network.

42. The apparatus according to any one of claims 31 to 41, wherein the transceiver unit is further configured to send a first decoding network parameter and first data codebook information, wherein the first decoding network determined based on the first decoding network parameter corresponds to the first encoding network, and the first data codebook information is for determining the first data codebook.

43. The apparatus according to any one of claims 31 to 41, wherein the transceiver unit is further configured to send a second decoding network parameter and second data codebook information, wherein a second decoding network determined based on the second decoding network parameter is for training to obtain the first decoding network, the first decoding network corresponds to the first encoding network, and the second data codebook information is for determining the second data codebook.

44. The apparatus according to any one of claims 32 to 43, wherein the transceiver unit is further configured to send a first information recovery network parameter, wherein the first information recovery network determined based on the first information recovery network parameter corresponds to the first information protection network.

45. The apparatus according to any one of claims 32 to 43, wherein the transceiver unit is further configured to send a second information recovery network parameter, wherein a second information recovery network determined based on the second information recovery network parameter is for training to obtain the first information recovery network, and the first information recovery network corresponds to the first information protection network.

46. A data transmission apparatus, wherein the apparatus comprises:
a transceiver unit, configured to receive information about an index of data, wherein the information about the index of the data is for determining the index of the data; and
a processing unit, configured to determine, based on a first data codebook, encoded data corresponding to the index of the data, wherein the first data codebook comprises a correspondence between the encoded data and the index.

47. The apparatus according to claim 46, wherein the transceiver unit is further configured to receive a bit sequence, and the processing unit is further configured to process the bit sequence based on a first information recovery network, to obtain the index of the data.

48. The apparatus according to claim 47, wherein the transceiver unit or the processing unit is further configured to obtain the first information recovery network.

49. The apparatus according to claim 47 or 48, wherein the first information recovery network is obtained through training based on channel state information and an index of training data, wherein the index of the training data is obtained based on a second encoding network and a second data codebook.

50. The apparatus according to claim 47 or 48, wherein the first information recovery network is obtained through training based on channel state information, an index of training data, and a loss function, wherein the loss function is associated with at least one of a codeword distance loss, an information reconstruction loss, and a sequence distance loss.

51. The apparatus according to any one of claims 46 to 50, wherein the processing unit is further configured to decode the encoded data based on a first decoding network, to obtain decoded data.

52. The apparatus according to claim 51, wherein the transceiver unit or the processing unit is further configured to obtain the first decoding network and the first data codebook.

53. The apparatus according to claim 51 or 52, wherein the first decoding network and the first data codebook are obtained through training based on the training data, the channel state information, a first channel protection network, the second encoding network, and the second data codebook, wherein the first channel protection network comprises a first information protection network and the first information recovery network, and the first information recovery network corresponds to the first information protection network.

54. The apparatus according to any one of claims 46 to 53, wherein a length of a codeword in the first data codebook and a quantity of codewords in the first data codebook are associated with a dimension of the encoded data.

55. The apparatus according to claim 54, wherein the quantity of codewords is associated with at least one of the following:
a compression rate of a data task network, a storage resource of the second apparatus, and performance of the data task network.

56. The apparatus according to claim 55, wherein the data task network comprises at least one of a first encoding network, the first data codebook, and the first decoding network, and the first encoding network corresponds to the first decoding network.

57. The apparatus according to any one of claims 51 to 56, wherein the transceiver unit is further configured to receive a first decoding network parameter and first data codebook information, wherein the first decoding network parameter and the first data codebook information are for determining the first decoding network and the first data codebook.

58. The apparatus according to any one of claims 51 to 56, wherein the transceiver unit is further configured to receive a second decoding network parameter and second data codebook information, wherein the second decoding network parameter is for determining a second decoding network, the second data codebook information is for determining the second data codebook, and the second decoding network and the second data codebook are for training to obtain the first decoding network and the first data codebook.

59. The apparatus according to any one of claims 47 to 58, wherein the transceiver unit is further configured to receive a first information recovery network parameter, wherein the first information recovery network parameter is for determining the first information recovery network.

60. The apparatus according to any one of claims 47 to 58, wherein the transceiver unit is further configured to receive a second information recovery network parameter, wherein a second information recovery network determined based on the second information recovery network parameter is for training to obtain the first information recovery network.

61. A communication apparatus, wherein the apparatus comprises a processor, the processor is coupled to a memory, and the memory stores instructions; and when the instructions are run by the processor,
the processor is enabled to perform the method according to any one of claims 1 to 15; or
the processor is enabled to perform the method according to any one of claims 16 to 30.

62. A communication apparatus, wherein the apparatus comprises a logic circuit, and the logic circuit is configured to: be coupled to an input/output interface, and communicate data through the input/output interface, to perform the method according to any one of claims 1 to 15, or perform the method according to any one of claims 16 to 30.

63. A computer-readable storage medium, wherein the computer-readable storage medium is configured to store a computer program; and when the computer program is run on a computer, the computer is enabled to perform the method according to any one of claims 1 to 15, or the computer is enabled to perform the method according to any one of claims 16 to 30.

64. A computer program product, wherein the computer program product comprises computer program code; and when the computer program code is run, the method according to any one of claims 1 to 15 is implemented, or the method according to any one of claims 16 to 30 is implemented.

65. A communication system, wherein the communication system comprises the apparatus according to any one of claims 31 to 45 and the apparatus according to any one of claims 46 to 60.
